# EUROPEAN PATENT APPLICATION

(11) **EP 4 628 557 A1**
(43) Date of publication of application: **08.10.2025**
(21) Application number: 23931874.4
(22) Date of filing: 27.12.2023
(51) Int. Cl.: C09J 7/30, C09J 7/10, C09J 123/08, C09J 11/06, C09J 11/08, H01L 31/048, H01L 31/055, C09K 11/06, C07D 249/18, C07D 249/20

(54) **LIGHT CONVERSION FILM COMPOSITION, LIGHT CONVERSION FILM, AND PHOTOVOLTAIC MODULE**

(30) Priority: 04.04.2023 CN 202310353493; 16.11.2023 CN 202311535255; 13.12.2023 CN 202311712843
(71) Applicant: Hangzhou First Applied Material Co., Ltd., Hangzhou, Zhejiang 311300 (CN)
(72) Inventor: LIU, Jin, Hangzhou, Zhejiang 311300 (CN); HU, Xiaobo, Hangzhou, Zhejiang 311300 (CN); YANG, Chufeng, Hangzhou, Zhejiang 311300 (CN); HOU, Hongbing, Hangzhou, Zhejiang 311300 (CN); ZHOU, Guangda, Hangzhou, Zhejiang 311300 (CN)
(74) Representative: Zacco GmbH
(86) International application number: PCT/CN2023/142487
(87) International publication number: WO 2024/207829

(57) **Abstract**

Provided in the present disclosure are light-conversion adhesive film composition, light-conversion adhesive film, and photovoltaic module. The light-conversion adhesive film composition includes, by weight percentage, 80-99.98% of a matrix resin, 0.01-10% of a light-conversion agent, and 0.01-10% of an auxiliary agent. The light-conversion agent is a benzotriazole derivative. A structural general formula of the benzotriazole derivative is as follows: 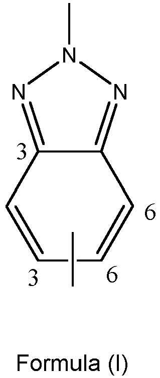 where an R substituent is of a formula (a), there is at least one R substituent in Sites 4 and 7 of the benzotriazole derivative, and there is at least one R substituent in Sites 5 and 6 of the benzotriazole derivative. The light-conversion adhesive film obtained from the light-conversion adhesive film composition expands an absorption range of a material in an ultraviolet light region, thereby improving the solubility and light-conversion efficiency of the light-conversion adhesive film, and a wider absorption range is obtained on the basis of ensuring the light stability of the light-conversion adhesive film, such that the corresponding light-conversion adhesive film may provide better protection and gain effects for battery assemblies.

## Description

This application is based upon and claims priority to Chinese Patent Applications No. 202310353493.6 filed on April 04, 2023, Chinese Patent Application No. 202311535255.3 filed on November 16, 2023, and Chinese Patent Application No. 202311712843.X filed on December 13, 2022, the disclosures of which are hereby incorporated again by reference in their entirety.

### Technical Field

The present disclosure relates to the technical field of photoelectricity, and specifically to light-conversion adhesive film composition, light-conversion adhesive film, and photovoltaic module.

### Background

In first aspect, solar energy is a renewable resource that is abundant and clean, such that the exploring of new technologies to use the solar energy more efficiently is of great research significance and practical values. At present, crystalline silicon batteries occupy a major position in the photovoltaic solar battery market, with mature production technology and stable applications. The technology of the crystalline silicon batteries is constantly innovated as market requirements for battery assembly efficiency continue to increase. Compared to most of PERC and TOPCon batteries on the market today, Heterojunction (HJT) batteries show significant advantages in terms of photoelectric conversion efficiency, and are expected to replace the former two and become a new generation of mainstream batteries. In recent years, the capacity of the HJT batteries has also not been on the rise.

However, compared to the PERC and TOPCon batteries, the HJT batteries are more sensitive to ultraviolet rays from sunlight. That is to say, the HJT batteries cannot effectively use the capability of the ultraviolet rays in sunlight, and the presence of ultraviolet rays also irreversibly damages the batteries, leading to a reduction in the service life of the batteries and photovoltaic conversion efficiency. Therefore, the development of a packaging material-light-conversion adhesive film, which may completely absorb ultraviolet light from the sun and convert it into visible light that may be used by a battery assembly, may not only effectively prevent the ultraviolet rays from damaging the battery assembly, but also have a beneficial effect on the photovoltaic conversion efficiency of the battery.

The key to develop the light-conversion adhesive film lies in the development of an appropriate light-conversion agent. According to the literature, compared with inorganic and organic and inorganic composite light-conversion agents, organic light-conversion agents are more advantageous in terms of price, structure, and adaptability to adhesive films. However, the disadvantage of organic light-conversion agents is the poor light stability. At present, an organic light-conversion agent based on a benzotriazole derivative has been reported in the literature, shows better light stability, and is a preferred material for the development of a high-performance light-conversion adhesive film.

However, the currently reported benzotriazole-based organic light-conversion agent has only one absorption peak at about 350 nm, with a narrow effective absorption range and insufficient absorption of ultraviolet light below 400 nm. This results in the corresponding light-conversion adhesive films not being able to effectively absorb the ultraviolet rays from sunlight, and thus the battery assemblies cannot be effectively protected.

In second aspect, a wavelength conversion technology means that: by selecting an appropriate light-conversion agent to dope in a polymer matrix, and using the absorption and conversion properties of the light-conversion agent to light, a solar spectrum is fully used. The technology was only used in agricultural film products in the early days. After 2000, with the development of the photovoltaic industry, scholars proposed the application of this technology (wavelength-conversion adhesive film) to photovoltaic apparatuses. Although the wavelength-conversion adhesive film is theoretically used to convert the ultraviolet light in sunlight that cannot be used by the photovoltaic apparatus into available visible light, such that the photoelectric conversion efficiency of the photovoltaic apparatus may be improved. However, the technology produces limited gain in the practical application of the PERC and TOPCon batteries.

However, with the development of the HJT battery technology in recent years, the importance of wavelength-conversion technology has been highlighted again. Compared to the PERC and TOPCon batteries, the HJT batteries have higher theoretical efficiency, such that the batteries are in an uptrend of rapid development, are expected to replace the PERC batteries, and become the mainstream of the market. However, the HJT batteries have a lower utilization rate to the ultraviolet light, the modules are ultraviolet-sensitive, and long-term exposure to the ultraviolet light leads to practical problems such as shortened service life of the module, which are problems that must be solved to make them a mature product. Compared to the optimization of the photovoltaic module itself, selecting the appropriate wavelength-conversion adhesive film is obviously a more direct and economical solution.

The core of the wavelength-conversion technology is to select an appropriate light-conversion agent. The wavelength light-conversion agents that have been reported at present mainly are organic light-conversion agents, inorganic light-conversion agents, and organic-inorganic composite light-conversion agents. However, by comprehensively taking the light-conversion performance (ultraviolet absorption, emission, and light-conversion efficiency) of the light-conversion agent, production costs, and indicators such as compatibility, dispersion, and multifunctionality in the adhesive film into consideration, the organic light-conversion agent has become the best choice. However, faced with basic requirements for the battery assemblies to maintain at least 20 years of service life, the disadvantage of an organic material itself in the light stability has become an important factor threatening its reliability. For example, it is reported that an organic dye rhodamine is used as the light-conversion agent to prepare the wavelength-conversion adhesive film to improve the efficiency of the photovoltaic apparatus, but is poor in light stability. In response to this, some researchers have reported a wavelength-conversion adhesive film based on a benzotriazole derivative organic light-conversion agent is greatly improved in terms of light stability, and showed excellent light-conversion performance. Therefore, a benzotriazole derivative system is an ideal light-conversion agent for the design and development of the wavelength-conversion adhesive film with high reliability and strong light-conversion capacity.

Existing wavelength light-conversion adhesive films using benzotriazole derivatives as light-conversion agents have shown good performance in terms of light stability as well as light-conversion capacity. However, in an actual use scenario (exposed to sunlight) of the photovoltaic module, a packaging adhesive film covering upper and lower surfaces of the photovoltaic module is inevitably in a high-temperature state (which may even reach over 90 degrees). In this case, there is a certain difference in concentration of the light-conversion agent between the upper surface adhesive film doped with the light-conversion agent and the lower surface adhesive film without the light-conversion agent, such that it is easy for the light-conversion agent to migrate downward. This leads to a great reduction in the ultraviolet absorption and conversion capacity of the upper surface adhesive film, thus affecting the efficiency and service life of the module.

In third aspect, as a clean energy source that is abundant and does not need to be transported, solar energy is expected to be an alternative energy source to traditional fossil fuels. Therefore, the development of a solar energy collection and conversion technology has gradually become the focus of national and social attention. The photovoltaic apparatus may directly convert the solar energy into electricity, which is one of the most efficient ways to use the solar energy. To date, the requirements for installed photovoltaic capacity continues to rise worldwide.

Since the vast majority of photovoltaic apparatuses can only effectively use the visible light in sunlight and the sunlight at near-infrared light wavebands, and the utilization efficiency of the ultraviolet light (with a wavelength less than 400 nm) in sunlight is relatively low. Moreover, the presence of the ultraviolet light in sunlight also reduces the service life of the photovoltaic apparatuses, especially for the HJT batteries, which are expected to replace the PERC and TOPCon as the third generation of solar cells. The use of the wavelength-conversion adhesive films may not only effectively fully absorb the ultraviolet light in sunlight to avoid damage to the service life of the photovoltaic apparatus; at the same time, the ultraviolet light may be converted into the available visible light, thereby improving the photoelectric conversion efficiency of the photovoltaic apparatus.

The technological core of the wavelength-conversion film lies in the selection of appropriate light-conversion agents, and existing light-conversion agents are mainly divided into inorganic light-conversion agents and organic light-conversion agents. Compared with the inorganic light-conversion agents, the organic light-conversion agents have the advantages of being cheap in price, various in category, easy to regulate the performance, etc. Moreover, since a substrate of the wavelength-conversion film belongs to an organic polymer material, the organic light-conversion agent tends to show better dispersion and compatibility with the substrate, and has less impact on the light transmission performance of the wavelength-conversion film. Conventional organic light-conversion agents are some small down-converted organic light-emitting molecules, which may well absorb the ultraviolet light, and convert same to the visible light (generally blue or sky blue light), and organic light-conversion agents are often natural light-conversion agent materials, but most of the organic light-conversion agents are poor in stability, and the corresponding adhesive films usually have a high rate of water vapor permeability, thereby greatly reducing the service life of the photovoltaic module.

### Summary

One of the main objectives of the present disclosure is to provide light-conversion adhesive film composition, light-conversion adhesive film, and photovoltaic module, so as to solve the problem of low photoelectric conversion efficiency and short service life of conventional adhesive films in the related art.

In order to implement the above objective, an aspect of the present disclosure provides a light-conversion adhesive film composition. The light-conversion adhesive film composition includes, by weight percentage, 80-99.98% of a matrix resin, 0.01-10% of a light-conversion agent, and 0.01-10% of an auxiliary agent. The light-conversion agent is a benzotriazole derivative. A structural general formula of the benzotriazole derivative is as follows.

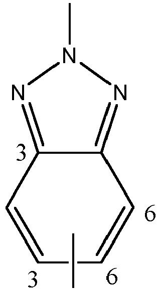

An R substituent is of 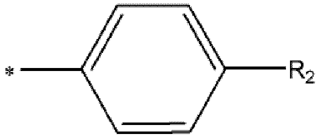 , there is at least one R substituent in Sites 4 and 7 of the benzotriazole derivative, and there is at least one R substituent in Sites 5 and 6 of the benzotriazole derivative; and R₁ and R₂ are each independently selected from any one of H, substituted or unsubstituted C₁-C₂₀ alkyl, C₃-C₂₀ alkyl with at least one methylene substituted by -COO- or -O-, and substituted or unsubstituted C₂-C₂₀ alkenyl, where substituents in the R₁ and R₂ are each independently selected from any one or more of methyl, ethyl, propyl, butyl, trifluoromethyl, and nitro.

Further, the R₁ and the R₂ are each independently selected from any one of substituted or unsubstituted C₅-C₁₀ alkyl, C₅-C₁₀ alkyl with at least one methylene substituted by -COO- or -O-, and C₅-C₁₀ alkenyl; and preferably, the R₁ and the R₂ are each independently selected from any one of any one of groups of pentyl, hexyl, heptyl, octyl, nonyl, and decyl each independently with at least one methylene substituted by -COO- or -O-, and from any one of pentyl, hexyl, heptyl, octyl, nonyl, decyl, pentenyl, hexenyl, heptenyl, octenyl, nonenyl, and decenoyl.

Further, the above benzotriazole derivative is selected from any one or more of 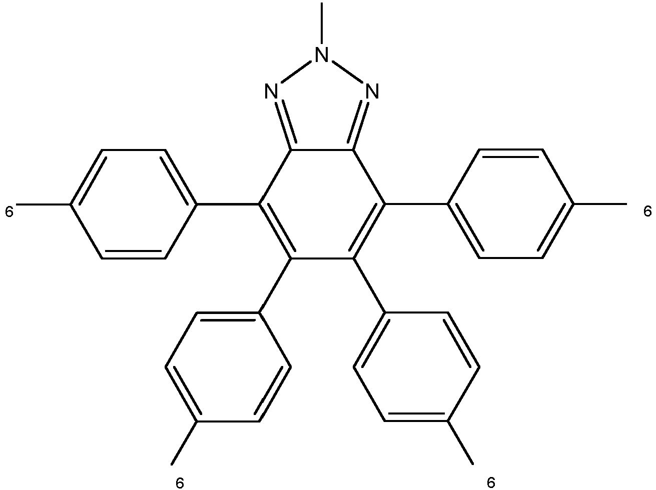 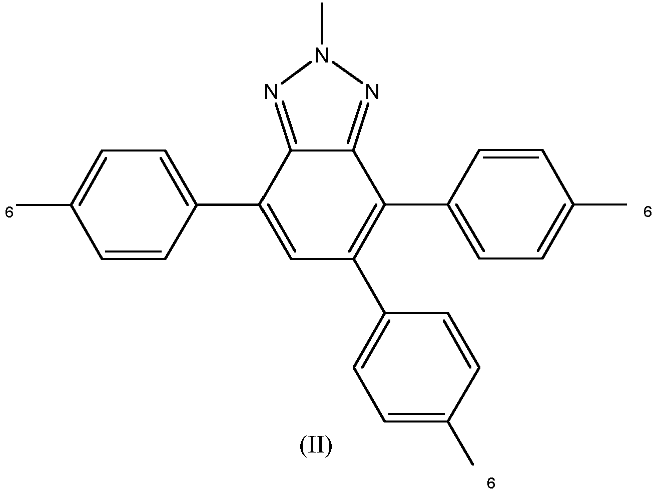 and 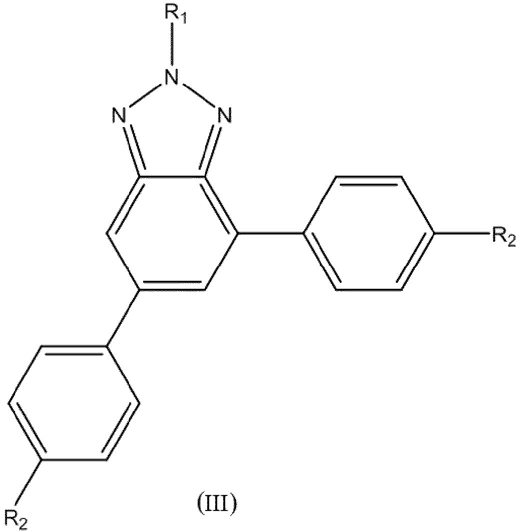 , R₁, R₃, R₄, R₅, and R₆ are each independently selected from any one of any one of groups of pentyl, hexyl, heptyl, octyl, nonyl, and decyl each independently with at least one methylene substituted by -COO- or -O-, and from any one of pentyl, hexyl, heptyl, octyl, nonyl, decyl, pentenyl, hexenyl, heptenyl, octenyl, nonenyl, and decenoyl.

Further, the above R₁, R₃, R₄, R₅, and R₆ are each independently selected from any one or more of tert-butyl, octyl, nonyl, hexenyl, heptenyl, octenyl, a butyric acid ethyl ester group, a butyric acid propyl ester group, a butyric acid butyl ester group, dipropyl ether, dibutyl ether, and butyl pentyl ether.

Further, the above benzotriazole derivative includes benzotriazole derivatives with structures shown in Formula (I) and (II), preferably, a molar ratio of the benzotriazole derivatives with structures shown in Formula (I) and (II) is 1:0.01-0.5.

Further, the above auxiliary agent includes a cross-linking agent and/or an auxiliary cross-linking agent; and preferably, a weight percentage of the cross-linking agent is 0.005-5%, and/or a weight percentage of the auxiliary cross-linking agent is 0.005-5%.

Further, the above auxiliary agent further includes a polyol compound; preferably, the mass of hydroxyl in the polyol compound is 0.1-20% of the mass of the polyol compound, preferably 0.5-10%; preferably, a molecular weight of the polyol compound is 500-80000; and preferably, the polyol compound is selected from any one or more of a polyvinyl alcohol compound, polyethylene glycol, and polypropylene glycol.

Further, the above matrix resin is selected from any one or more of EVA, PVA, PMMA, POE, and organosilicon.

Another aspect of the present disclosure provides a light-conversion adhesive film, which is prepared by mixing and molding an adhesive film composition. The adhesive film composition is the above light-conversion adhesive film composition.

Another aspect of the present disclosure provides a photovoltaic module, including a light-conversion adhesive film. The light-conversion adhesive film is the above light-conversion adhesive film.

By using the technical solutions of the present disclosure, the benzotriazole derivative of the present disclosure uses a benzotriazole structure as a core, the R substituent is modified at the periphery of a benzotriazole benzene ring, a D-A interaction (charge transfer excited state) in molecules is formed through a conjugation effect between the benzene rings, so as to constitute a light-emitting core. It is widely known that, in addition to intrinsic absorption (generally within 300 nm) of a group in the molecule, the absorption of D-A type organic molecule also includes charge transfer transition absorption (between 300 and 400 nm) from a donor group to an acceptor group.

In the benzotriazole derivative of the present disclosure, the donor group is a peripheral R substituent, and the acceptor group is the benzotriazole located in the center of the benzotriazole derivative. Sites 4 and 7 of the benzotriazole derivative are symmetrical to each other, and sites 5 and 6 are symmetrical to each other, while Site 4 (7) and Site 5 (6) in the present disclosure are modified with the R substituents. Since the Site 4 (7) and the Site 5 (6) have different transition energy levels, two different absorption peaks but between 300 and 400 nm are generated when charge transfer transition occurs in the benzotriazole derivative, to expand an absorption range of a material in an ultraviolet region, so as to solubility and light-conversion efficiency, thereby further obtaining a wider absorption range on the basis of ensuring the light stability of a light-conversion adhesive film, such that the corresponding light-conversion adhesive film may provide better protection and beneficial effect for a battery assembly.

The second main objective of the present disclosure is to provide wavelength-conversion adhesive film composition, wavelength-conversion adhesive film, and photovoltaic module, so as to solve the problem of low photoelectric conversion efficiency and short service life of a photovoltaic module caused by light-conversion agent migration easily occurred in a wavelength-conversion adhesive film using a benzotriazole derivative as a light-conversion agent in the related art.

In order to implement the above objective, an aspect of the present disclosure provides a wavelength-conversion adhesive film composition. The wavelength-conversion adhesive film composition includes, by weight percentage, 80-99.98% of a matrix resin, 0.01-10% of a light-conversion agent, and 0.01-10% of an auxiliary agent. The light-conversion agent is a benzotriazole derivative. A structural general formula of the benzotriazole derivative is as follows: 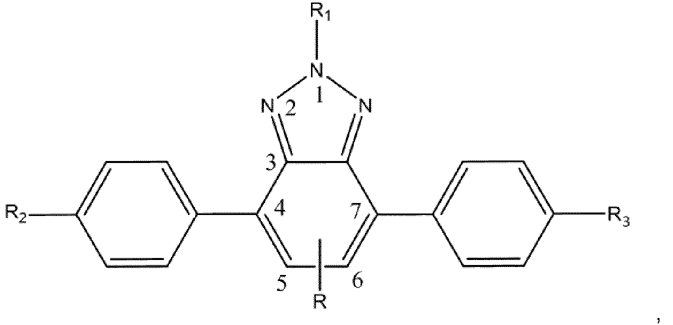 where R₁ and R are each independently selected from any one of substituted or unsubstituted CH₂=HC-R'-*, substituted or unsubstituted C₁-C₂₀ alkyl, substituted or unsubstituted C₁-C₂₀ alkoxy, substituted or unsubstituted C₁-C₂₀ easter group, and substituted or unsubstituted C₁-C₂₀ amino, and R' is a straight bond or C₁-C₂₀ alkylene; R₂ and R₃ are each independently selected from any one of H, C₁-C₂₀ hydrocarbyl, and C₃-C₂₀ hydrocarbyl with at least one methylene substituted by -COO-; and a maximum absorption wavelength of the light-conversion agent is located between 300 and 400 nm, and a maximum emission wavelength is greater than 400 nm.

Further, any methylene in the above R₁ and R is substituted by any one of , -COO-, and -O-; preferably, R' is a straight bond or C₁-C₈ alkylene, and the R₁ and R are each independently selected from substituted or unsubstituted C₁-C₈ alkyl, substituted or unsubstituted C₁-C₈ alkoxy, substituted or unsubstituted C₁-C₈ ester group, and substituted or unsubstituted C₁-C₈ amino; preferably, the R₁ and R are each independently selected from any one of C₁-C₈ straight chain alkyl, C₃-C₈ branched alkyl, and C₁-C₈ alkoxy; preferably, the R₁ and R are each independently selected from any one of methyl, methoxy, ethyl, ethoxy, propyl, propoxy, butyl, butoxyl, pentyl, pentyloxy, hexyl, hexyloxy, heptyl, heptyloxy, octyl, octyloxy, vinyl, allyl, alkenylbutyl, alkenylpentyl, alkenylhexyl, alkenylheptyl, alkenyloctyl, 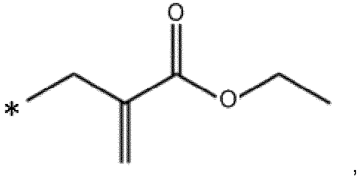 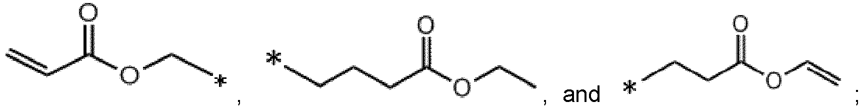 and further preferably, the R₁ and R are each independently selected from any one of alkenyloctyl, heptyl,

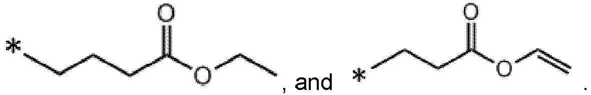

Further, the R₁ and R respectively are substituents capped with unsaturated substituted functional groups, preferably, the unsaturated substituted functional group is selected from any one of alkenyl hydrocarbyl, an acrylic group, and an acrylate group; preferably, the unsaturated substituted functional group is vinyl; and/or when the R₁ and R have substituents, the substituent is selected from any one or more of methyl, ethyl, propyl, butyl, trifluoromethyl, and nitro.

Further, the above R₂ and the R₃ are each independently selected from any one or more of H, C₁-C₁₀ hydrocarbyl, and C₃-C₁₀ hydrocarbyl with at least one methylene substituted by -COO-, and preferably, the R₂ and the R₃ are each independently selected from any one or more of 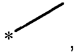 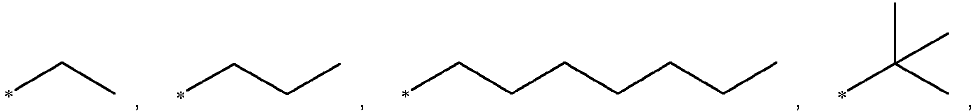 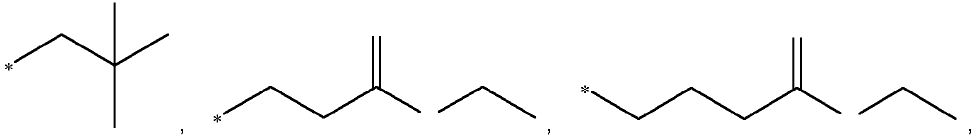 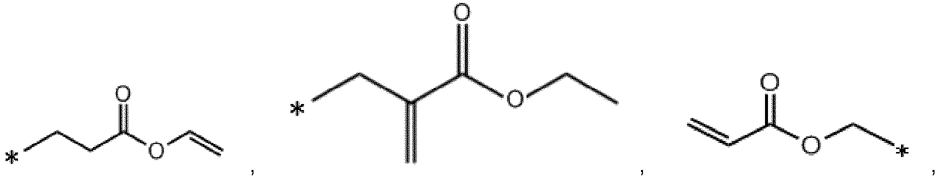 and 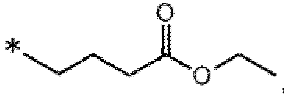 where "*" indicates connection sites of the R₂ and the R₃ on benzene rings on which they are located.

Further, the above benzotriazole derivative is selected from any one or more of

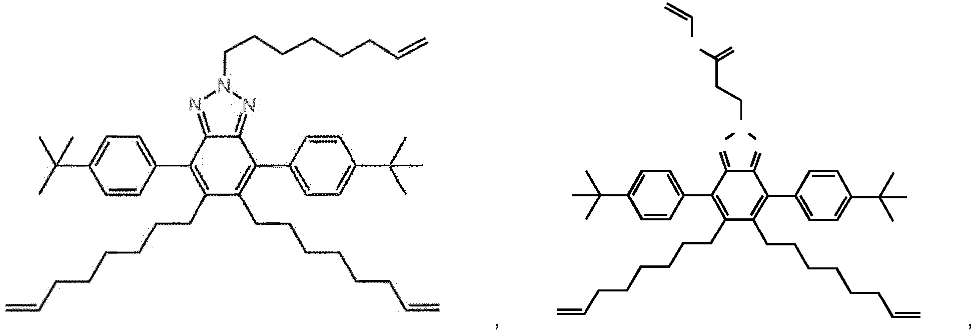

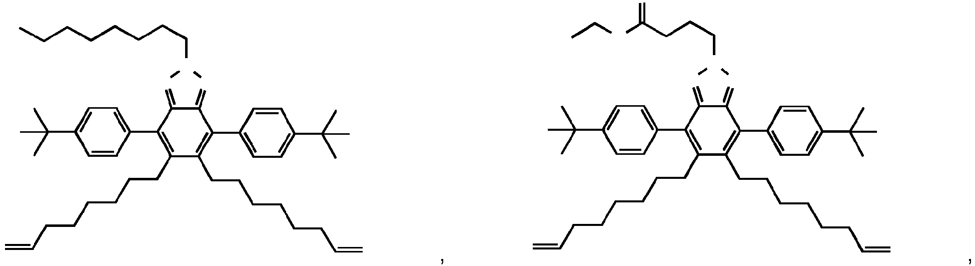

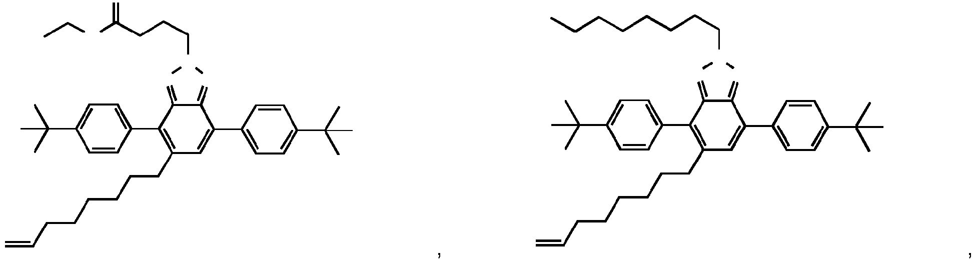

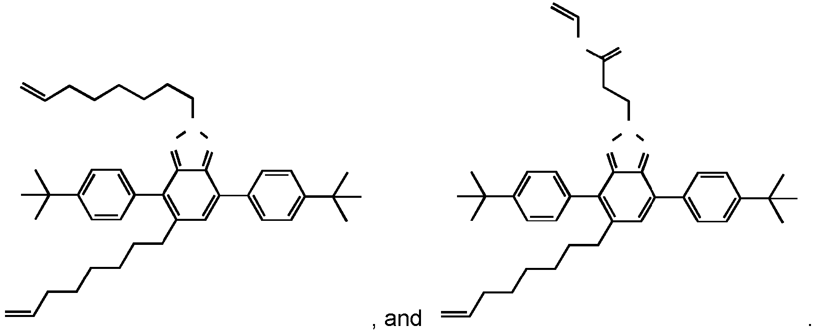

Further, the above auxiliary agent includes a cross-linking agent and/or an auxiliary cross-linking agent; and preferably, a weight percentage of the cross-linking agent is 0.005-5%, and/or a weight percentage of the auxiliary cross-linking agent is 0.005-5%.

Further, the above auxiliary agent further includes a polyol compound; preferably, the mass of hydroxyl in the polyol compound is 0.1-20% of the mass of the polyol compound, preferably 0.5-10%; preferably, a molecular weight of the polyol compound is 500-80000; and preferably, the polyol compound is selected from any one or more of a polyvinyl alcohol compound, polyethylene glycol, and polypropylene glycol.

Further, the above matrix resin is selected from any one or more of EVA, PVA, PMMA, POE, and organosilicon.

Another aspect of the present disclosure provides a wavelength-conversion adhesive film, which is prepared by mixing and molding an adhesive film composition. The adhesive film composition is the foregoing wavelength-conversion adhesive film composition.

Another aspect of the present disclosure provides a photovoltaic module, including a light-conversion adhesive film. The light-conversion adhesive film is the foregoing wavelength-conversion adhesive film composition.

By using the technical solutions of the present disclosure, in the present disclosure, a structure of the benzotriazole derivative is optimized, and in addition to connecting an alkyl-substituted benzene ring at the Sites 4 and 7 of the benzotriazole derivative to realize molecular light-conversion performance, functional substituent groups are also connected at the Sites 5 and/or 6 of the benzotriazole derivative and a No. 2 N atom to realize the multifunctionality of the light-conversion agent. Preferably, the R, R₁, R₂, and R₃ facilitate the improvement of the solubility of the light-conversion agent in an adhesive film, such that migration and aggregation of the light-conversion agent in the adhesive film may be inhibited, and absorption and emission spectra of the light-conversion agent may be optimized according to requirements, so as to meet use requirements of assemblies from different manufacturers in different scenarios. Furthermore, even when there is a concentration difference in the light-conversion agent in the adhesive film, a migration rate of the light-conversion agent at a high temperature is greatly reduced.

The third main objective of the present disclosure is to provide light-conversion adhesive film composition, light-conversion adhesive film, and photovoltaic module, so as to solve the problem of low photoelectric conversion efficiency, poor stability, and short service life of conventional adhesive films in the related art.

In order to implement the above objective, an aspect of the present disclosure provides a wavelength-conversion adhesive film composition. The light-conversion adhesive film composition includes, by weight percentage, 80%-99.98% of a matrix resin, 0.01%-10% of a light-conversion agent, and 0.01%-10% of an auxiliary agent. The light-conversion agent is a benzotriazole compound. A structural general formula of the benzotriazole compound is as follows:

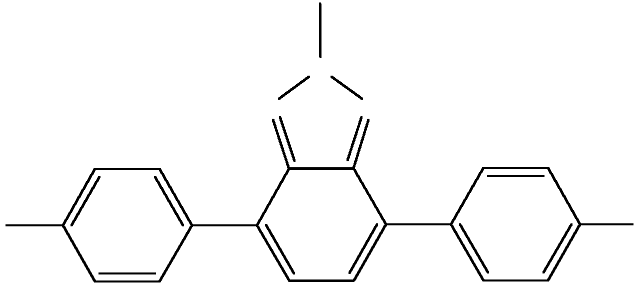

R₁ is C₃-C₂₀ alkyl with at least one methylene substituted by -COO-, and R₂ and R₃ are each independently selected from any one or more of H, C₁-C₂₀ alkyl, and C₃-C₂₀ alkyl with at least one methylene substituted by -COO-; and the auxiliary agent includes a polyol compound.

Further, the above light-conversion adhesive film composition includes, by weight percentage, 98%-99.98% of the matrix resin, 0.01%-1% of the light-conversion agent, and 0.01%-1% of the auxiliary agent; and further preferably, a mass ratio of the light-conversion agent to the auxiliary agent is 1:2-500, preferably 1:2-50.

Further, the mass of hydroxyl in the above polyol compound is 0.1-20% of the mass of the polyol compound, preferably 0.5-10%; preferably, a molecular weight of the polyol compound is 500-80000; and preferably, the polyol compound is selected from any one or more of a polyvinyl alcohol compound, polyethylene glycol, and polypropylene glycol.

Further, the above auxiliary agent further includes a polyester compound; preferably, a molecular weight of the polyester compound is 500-80000; preferably, a mass ratio of the polyol compound to the polyester compound is 1:0.01-1; preferably, the mass ratio of the polyol compound to the polyester compound is 1:0.1-0.5; preferably, the polyester compound is aliphatic polyester and/or aromatic polyester; preferably, the aromatic polyester is polyethylene terephthalate; preferably, the aliphatic polyester is selected from any one or more of a polyester compound obtained through polymerization of C₂-C₁₂ aliphatic diprotic acid and C₂-C₁₂ alkyl dihydric alcohol, and polyurethane; and preferably, the aliphatic polyester is selected from any one or more of polyurethane, poly butylenes succinate, poly(methyl methacrylate), polyethylene glycol ester, and polyhydroxybutyrate.

Further, the above R₁ is C₃-C₁₀ alkyl with at least one methylene substituted by -COO-, and preferably, the R₁ is selected from any one or more of 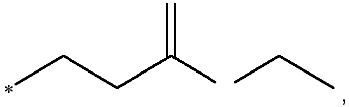 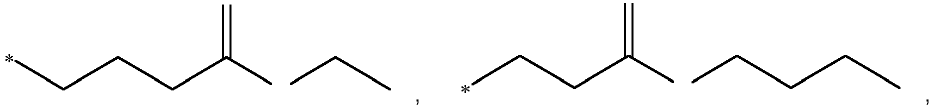 and 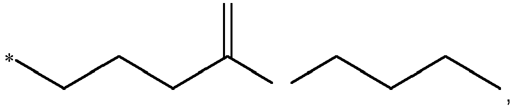 where "*" indicates a connection site of the benzotriazole compound with the R₁ except the portion of the R₁.

Further, the above R₂ and the R₃ are each independently selected from any one or more of H, C₁-C₁₀ alkyl, and C₃-C₁₀ alkyl with at least one methylene substituted by -COO-, and preferably, the R₂ and the R₃ are each independently selected from any one or more of 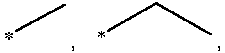 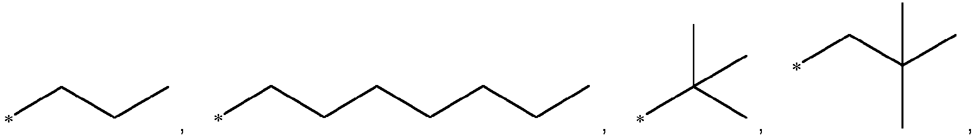 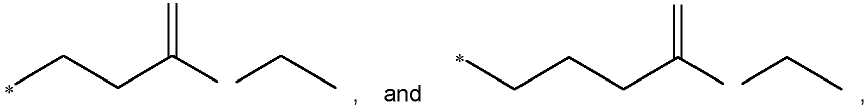 where "*" indicates a connection site of the benzotriazole compound with the R₂ except the portion of the R₂; and further preferably, the R₂ is the same as the R₃, and preferably, the benzotriazole compound is selected from any one or more of 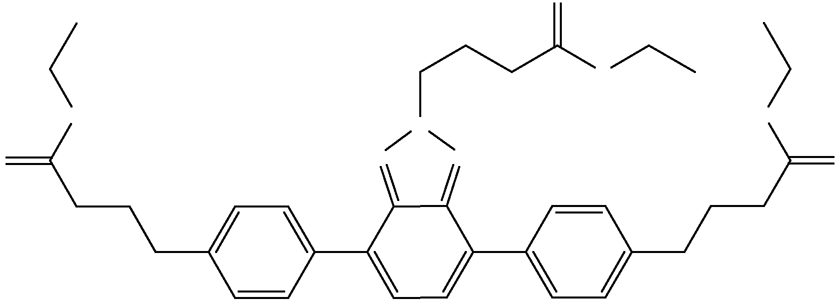 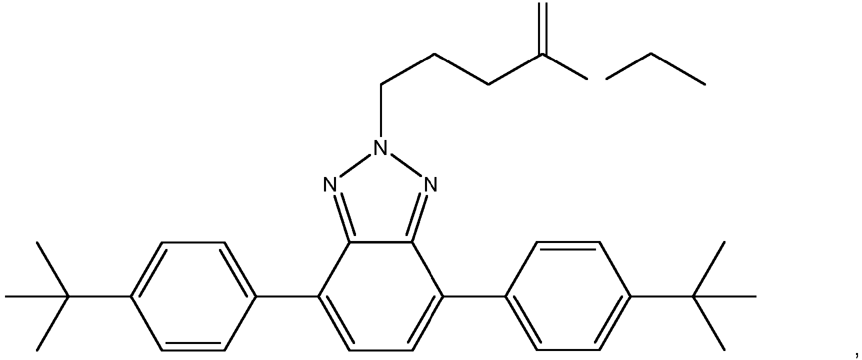 and

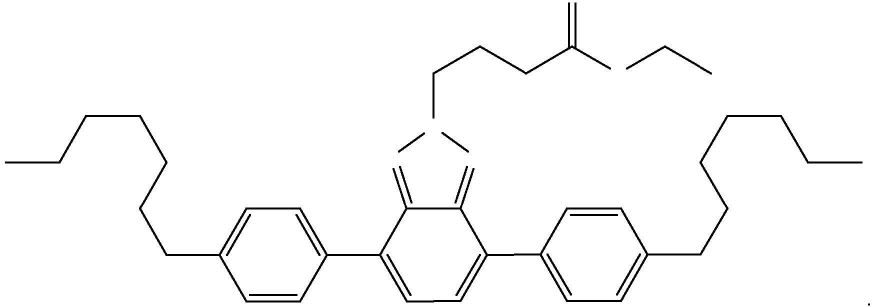

Further, the above matrix resin is selected from any one or more of EVA, PVA, PMMA, POE, and organosilicon.

Further, based on a total mass of the above matrix resin, light-conversion agent, and auxiliary agent being 100%, the light-conversion adhesive film composition further includes 0.01-1% of a cross-linking agent, preferably 0.01-0.5%.

Another aspect of the present disclosure provides a light-conversion adhesive film, which is prepared by mixing and molding an adhesive film composition. The adhesive film composition is the above light-conversion adhesive film composition.

Another aspect of the present disclosure provides a photovoltaic module, including a light-conversion adhesive film. The light-conversion adhesive film is the foregoing light-conversion adhesive film.

By using the technical solutions of the present disclosure, the ester group contained in the R₁ at the No. 2 N position of benzotriazole provides a first protective layer for the benzotriazole light-emitting core. Moreover, the ester group having an oxygen atom may also form an interaction such as a hydrogen bond with the matrix resin to improve the compatibility of the light-conversion agent and the matrix resin, thereby providing a second protective layer to the light-emitting core structure. The benzotriazole compound is not very compatible with the matrix resin due to its high rigidity. An alkyl main chain of the polyol compound auxiliary agent has a component similar to the matrix resin, and a hydrogen bond is formed by a hydroxyl functional group contained in a side chain of the polyol compound auxiliary agent and an ester functional group of the light-conversion agent, such that the compatibility of the light-conversion agent and the matrix resin is improved under the dual action of similar compatibility and hydrogen bonding, and the protection effect of the matrix resin to the light-conversion agent is achieved at the same time, so as to provide a third protective layer for the light-emitting core structure, thereby improving the stability of the light-conversion agent under the above multiple protective effects, and optimizing a film formation effect. Furthermore, the motion of the light-conversion agent inside the matrix resin is further limited due to the effect of the hydrogen bond, an energy loss during molecular luminescence is reduced, the rigidity of molecules in the light-conversion agent is improved, and the purpose of light-conversion efficiency is improved finally. Therefore, the light-conversion adhesive film obtained by using the light-conversion adhesive film composition of the present disclosure has excellent light stability and high light-emitting efficiency, and may be effective for a long time, thereby improving the service life of a photovoltaic apparatus.

### Brief Description of the Drawings

The drawings, which form a part of the present disclosure, are used to provide a further understanding of the present disclosure. The exemplary embodiments of the present disclosure and the description thereof are used to explain the present disclosure, but do not constitute improper limitations to the present disclosure. In the drawings:

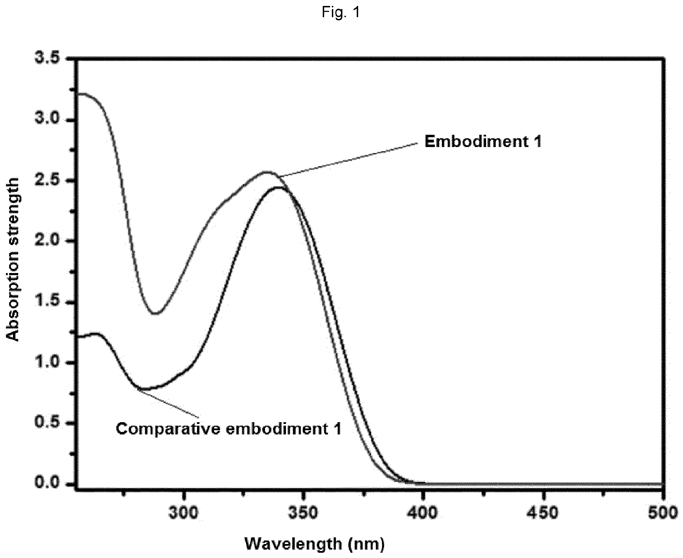

Fig. 1 is an absorption strength diagram of light-conversion adhesive films respectively provided in Embodiment 1 and Comparative embodiment 1 at different wavelengths according to the present disclosure.

### Detailed Description of the Embodiments

It is to be noted that the embodiments in the present disclosure and the features in the embodiments may be combined with one another without conflict. The present disclosure will be described below in detail with reference to the drawings and the embodiments.

As analyzed in the first aspect of the Background, there is the problem of low photoelectric conversion efficiency and short service life of conventional adhesive films in the related art. In order to solve the problem, the present disclosure provides light-conversion adhesive film composition, light-conversion adhesive film, and photovoltaic module.

A typical implementation of the present disclosure provides a light-conversion adhesive film composition. The light-conversion adhesive film composition includes, by weight percentage, 80-99.98% of a matrix resin, 0.01-10% of a light-conversion agent, and 0.01-10% of an auxiliary agent. The light-conversion agent is a benzotriazole derivative. A structural general formula of the benzotriazole derivative is as follows.

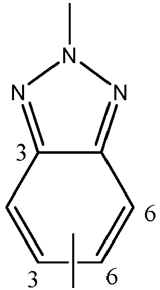

An R substituent is of a 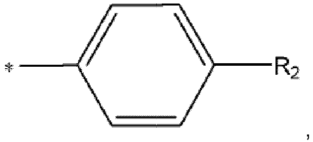 there is at least one R substituent in Sites 4 and 7 of the benzotriazole derivative, and there is at least one R substituent in Sites 5 and 6 of the benzotriazole derivative; and R₁ and R₂ are each independently selected from any one of H, substituted or unsubstituted C₁-C₂₀ alkyl, C₃-C₂₀ alkyl with at least one methylene substituted by -COO- or -O-, and substituted or unsubstituted C₂-C₂₀ alkenyl, where substituents in the R₁ and R₂ are each independently selected from any one or more of methyl, ethyl, propyl, butyl, trifluoromethyl, and nitro.

The benzotriazole derivative of the present disclosure uses a benzotriazole structure as a core, the R substituent is modified at the periphery of a benzotriazole benzene ring, a D-A interaction (charge transfer excited state) in molecules is formed through a conjugation effect between the benzene rings, so as to constitute a light-emitting core. It is widely known that, in addition to intrinsic absorption (generally within 300 nm) of a group in the molecule, the absorption of D-A type organic molecule also includes charge transfer transition absorption (between 300 and 400 nm) from a donor group to an acceptor group.

In the benzotriazole derivative of the present disclosure, the donor group is a peripheral R substituent, and the acceptor group is the benzotriazole located in the center of the benzotriazole derivative. Sites 4 and 7 of the benzotriazole derivative are symmetrical to each other, and sites 5 and 6 are symmetrical to each other, while Site 4 (7) and Site 5 (6) in the present disclosure are modified with the R substituents. Since the Site 4 (7) and the Site 5 (6) have different transition energy levels, two different absorption peaks but between 300 and 400 nm are generated when charge transfer transition occurs in the benzotriazole derivative, to expand an absorption range of a material in an ultraviolet region, so as to solubility and light-conversion efficiency, thereby further obtaining a wider absorption range on the basis of ensuring the light stability of a light-conversion adhesive film, such that the corresponding light-conversion adhesive film may provide better protection and beneficial effect for a battery assembly.

In some embodiments of the present disclosure, the R₁ and the R₂ are each independently selected from any one of substituted or unsubstituted C₅-C₁₀ alkyl, C₅-C₁₀ alkyl with at least one methylene substituted by -COO- or -O-, and C₅-C₁₀ alkenyl; and preferably, the R₁ and the R₂ are each independently selected from any one of any one of groups of pentyl, hexyl, heptyl, octyl, nonyl, and decyl each independently with at least one methylene substituted by -COO- or -O-, and from any one of pentyl, hexyl, heptyl, octyl, nonyl, decyl, pentenyl, hexenyl, heptenyl, octenyl, nonenyl, and decenoyl.

Preferably, the R₁ and R₂ are more conducive to achieving a cooperative interaction effect between the two, for example, improving the interaction such as a hydrogen bond formed by the R₁ and the matrix resin, thereby improving the compatibility of the light-conversion agent and the matrix resin, and providing a more favorable protective layer to the light-emitting core structure.

In order to improve the performance such as light stability, light-conversion efficiency, etc. of the light-conversion agent, preferably, the above benzotriazole derivative is selected from any one or more of 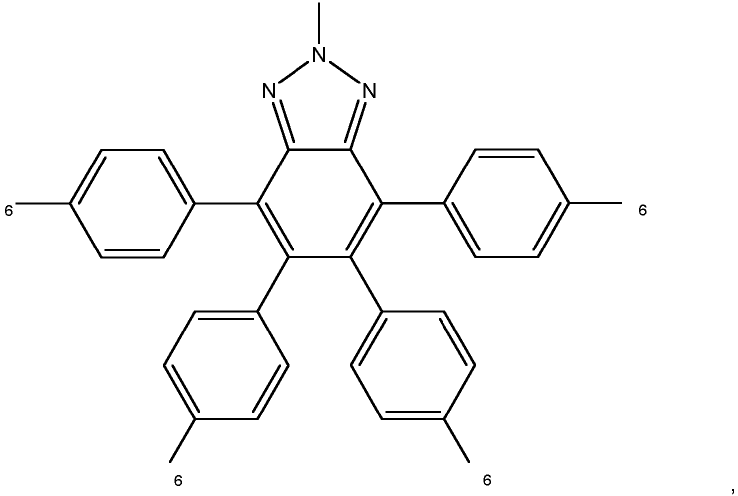 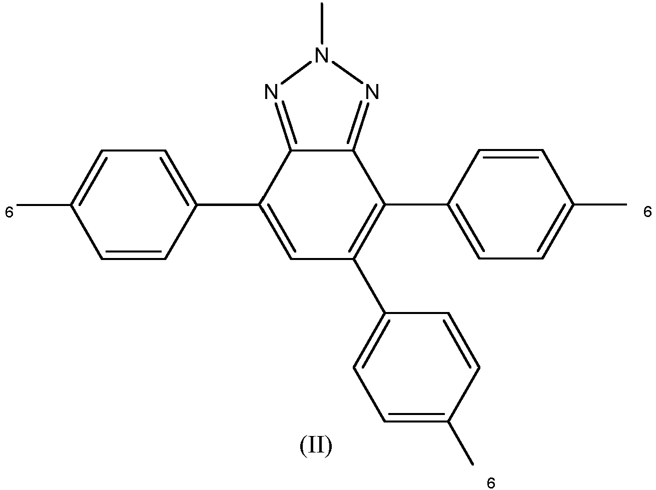 and 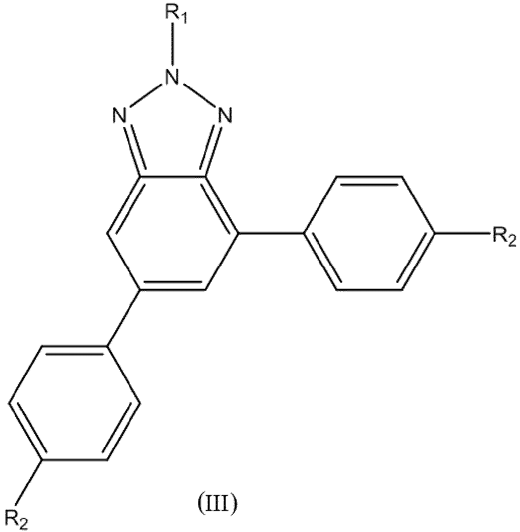 , R₁, R₃, R₄, R₅, and R₆ are each independently selected from any one of any one of groups of pentyl, hexyl, heptyl, octyl, nonyl, and decyl each independently with at least one methylene substituted by -COO- or -O-, and from any one of pentyl, hexyl, heptyl, octyl, nonyl, decyl, pentenyl, hexenyl, heptenyl, octenyl, nonenyl, and decenoyl.

In an embodiment of the present disclosure, the above R₁, R₃, R₄, R₅, and R₆ are each independently selected from any one or more of tert-butyl, octyl, nonyl, hexenyl, heptenyl, octenyl, a butyric acid ethyl ester group, a butyric acid propyl ester group, a butyric acid butyl ester group, dipropyl ether, dibutyl ether, and butyl pentyl ether.

Preferably, the above types of benzotriazole derivatives are more conductive to collaborative cooperation with the matrix resin and the auxiliary agent, thereby improving the light-conversion efficiency of the light-conversion adhesive film.

In an embodiment of the present disclosure, the above benzotriazole derivative includes benzotriazole derivatives with structures shown in Formula (I) and (II), preferably, a molar ratio of the benzotriazole derivatives with structures shown in Formula (I) and (II) is 1:0.01-0.5.

There are more R substituents on the benzotriazole derivatives with the structures shown in (I) and (II), causing the benzotriazole derivative molecules themselves distorted to a large extent, and more R substituents tend to produce more electron transitions; in particular, the above benzotriazole derivatives with the structures shown in (I) and (II) are preferably used as light-conversion agents, and by controlling a molar ratio of the benzotriazole derivatives within the above range, the collaborative cooperation effect between the benzotriazole derivatives is improved, thereby improving the light-conversion efficiency of the light-conversion adhesive film.

In an embodiment of the present disclosure, the above auxiliary agent includes a cross-linking agent and/or an auxiliary cross-linking agent; and preferably, a weight percentage of the cross-linking agent is 0.005-5%, and/or a weight percentage of the auxiliary cross-linking agent is 0.005-5%.

The cross-linking agent is a molecule having a plurality of olefinic unsaturated groups, which may promote the cross-linking of polymers, thereby achieving a higher degree of cross-linking. The cross-linking agent in the above composition may be selected from those commonly used in the art. Preferably, the cross-linking agent is selected from any one or more of tert butyl peroxide isopropyl carbonate, 2,5-dimethyl-2,5-di(tert-butylperoxy)hexane, tert-butylperoxy 2-ethylhexyl carbonate, 1,1-di-(tert-butylperoxy)-3,3,5-trimethylcyclohexane, 1,1-bis(tert-amylperoxy)-3,3,5-trimethylcyclohexane, 1,1-bis(tert-amylperoxy)cyclohexane, 1, 1-di(tert-butylperoxy)cyclohexane, 2,2-bis(tert-butylperoxy)butane, tert-amylperoxy 2-ethylhexyl carbonate, 2,5-dimethyl-2,5-dimethyl-2,5-dimethyl-di-(benzoyl peroxy) hexane, tert amyl peroxycarbonate, and tert-butyl peroxy-3,3,5-trimethylhexanoate. Preferably, the auxiliary cross-linking agent is selected from any one or more of triallyl isocyanurate, triallyl cyanurate, trimethylolpropane triacrylate, trimethylolpropane trimethacrylate, pentaerythritol triacrylate, isocyanuric acid tris(2-acryloyloxyethyl) ester, ethoxylated trimethylolpropane triacrylate, trimethylolpropane triacrylate, ethoxylated glycerol triacrylate, glyceryl propoxy triacrylate, pentaerythritol tetraacrylate, ethoxylated pentaerythitol tetraacrylate, trimethylolpropane tetraacrylate, di(trimethylolpropane) tetraacrylate, bis(trimethylolpropane) tetramethylacrylate, propoxylated pentaerythritol tetra-acrylate, 2,4,6-tris(2-propenyloxy)-1,3,5-triazine, tricyclic cyclohexane dimethanol diacrylate, propylene oxide neopentyl glycol diacrylate, ethoxylated (10) bisphenol A diacrylate, ethoxylated bisphenol A dimethacrylate, 2-butyl-2-ethyl-1,3-propylene glycol diacrylate, diethylene glycol dimethacrylate, triethylene glycol dimethacrylate, and poly(ethylene glycol) dimethacrylate.

In an embodiment of the present disclosure, the above auxiliary agent further includes a polyol compound; preferably, the mass of hydroxyl in the polyol compound is 0.1-20% of the mass of the polyol compound, preferably 0.5-10%; preferably, a molecular weight of the polyol compound is 500-80000; and preferably, the polyol compound is selected from any one or more of a polyvinyl alcohol compound, polyethylene glycol, and polypropylene glycol.

The benzotriazole derivative is not very compatible with the matrix resin due to its high rigidity. An alkyl main chain of the polyol compound auxiliary agent has a component similar to the matrix resin, and a hydrogen bond is formed by a hydroxyl functional group contained in a side chain of the polyol compound auxiliary agent and an ester functional group of the light-conversion agent. Preferably, the content of the hydroxyl in the polyol compound is within the above range, the compatibility of the light-conversion agent and the matrix resin is improved, such that the compatibility of the light-conversion agent and the matrix resin is further improved under the dual action of similar compatibility and hydrogen bonding.

In an embodiment of the present disclosure, the above auxiliary agent further includes a thickening agent. The addition of the thickening agent may improve the adhesion between the adhesive film and a substrate. In a preferred embodiment, the thickening agent includes, but is limited to, one or more of a group consisting of γ-aminopropyltriethoxysilane, γ-Methacηloyloxypropyl trimethoxysilane, γ-(2,3-epoxypropoxy)propyltrimethoxysilane, vinyltrimethoxysilane, n-β-(aminoethyl)-γ-aminopropyltrimethoxysilane, γ-glycidyloxypropyltrimethoxysilane, and 3-aminopropyltrimethylsilane.

In some embodiments of the present disclosure, preferably, the above matrix resin is selected from any one or more of EVA, PVA, PMMA, POE, and organosilicon, and thus better cooperate with components such as the light-conversion agent, so as to obtain the light-conversion adhesive film with excellent performance. The above matrix resin is cheap in price, facilitating reduction in cost. Definitely, other base resins may be used by those skilled in the art and are not described herein again.

In an embodiment of the present disclosure, based on a total mass of the above matrix resin, light-conversion agent, and auxiliary agent being 100%, the light-conversion adhesive film composition further includes 0.01-1 % of a cross-linking agent, preferably 0.01-0.5%.

Preferably, the foregoing light-conversion agent is conductive to synergizing with the cross-linking agent, so as to improve the cross-linking effect of the cross-linking agent thereby improving the performance of the light-conversion adhesive film.

Another typical implementation of the present disclosure provides a light-conversion adhesive film, which is prepared by mixing and molding an adhesive film composition. The adhesive film composition is the foregoing light-conversion adhesive film composition.

In some preferred embodiments of the present disclosure, after the foregoing light-conversion adhesive film composition is well mixed, the light-conversion adhesive film is obtained through preparation using preparation processes such as melt extrusion molding at 80-120 °C. The obtained light-conversion adhesive film has excellent stability and high light-emitting efficiency, and may be effective for a long time, thereby improving the service life of a photovoltaic apparatus.

Another typical implementation of the present disclosure provides a photovoltaic module, including a light-conversion adhesive film. The light-conversion adhesive film is the above light-conversion adhesive film.

The photovoltaic module including the above light-conversion adhesive film of the present disclosure has excellent light-conversion efficiency. Definitely, there may be more choices according to different requirements and application scenarios. The light-conversion adhesive film of the present disclosure is not limited to a photovoltaic apparatus, an agricultural film, architectural glass, and other fields.

The beneficial effects of the present disclosure are further described below with reference to the embodiments.

### Embodiment 1

A light-conversion adhesive film composition included, by weight, 98.8 of parts of ethylene-vinyl acetate, 0.2 parts of a benzotriazole compound (having a structure shown in (I)), 0.5 parts of a cross-linking agent tert butyl peroxide isopropyl carbonate, and 0.5 parts of an auxiliary cross-linking agent trimethylolpropane tetraacrylate. A synthetic route of the benzotriazole derivative with the structure shown in (I) was shown as follows: 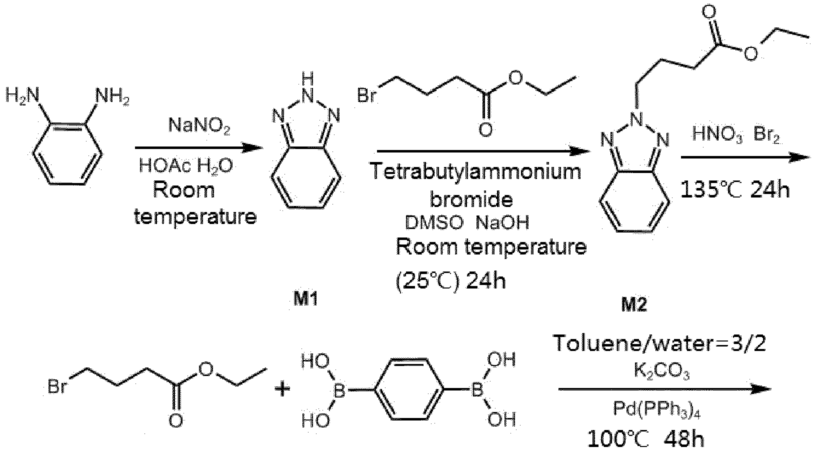 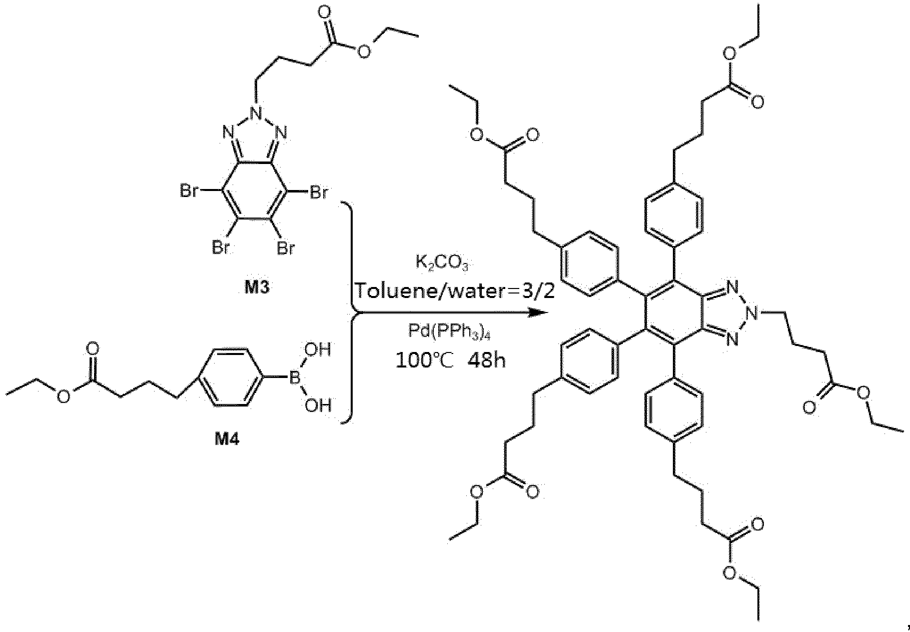 and the light-conversion adhesive film composition was well mixed, and then melt extrusion and film formation were performed at 100 °C, so as to obtain a light-conversion adhesive film.

### 1. Synthesis of M1

In a double-necked flask, o-phenylenediamine (3.67 g, 34 mmol) was heated to dissolve in 60 mL glacial acetic acid. While stirring, an aqueous solution (30mL) of sodium nitrite (2.76 g, 40 mmol) was slowly added dropwise. After a reaction solution was clear, stirring was continuously performed for 2 h, and the reaction was stopped. The reaction solution was placed at -10 °C for low-temperature freezing, and white solid powder was precipitated, filtered, washed with water to obtain a white crude product. 3 g of pure white crystalline powder was obtained after recrystallization, with a yield being 75%.

### 2. Synthesis of M2

A mixture of the M1 (2 g, 16.8 mmol), ethyl 4-bromobutyrate (3.92 g, 20 mmol), potassium carbonate (6.96 g, 50 mmol), and N,N-dimethylformamide (50 mL) was stirred under nitrogen, and heated for 2 days at 40 °C. The reaction mixture was poured in ice water and extracted with dichloromethane, an organic phase obtained through extraction was dried with magnesium sulfate anhydrous, and then vacuum distillation was performed to obtain a transparent oily droplet crude product. Column chromatography separation and purification were performed, a petroleum ether/dichloromethane mixed solvent was used as an eluent, and 2.3 g of a light yellow oily pure product was obtained finally, with a yield being 60%.

### 3. Synthesis of M3

The M2 (2 g, 8.6 mmol) was dissolved in 20 mL nitric acid, and heated. While stirring, bromine (6.9 g, 43 mmol) was slowly added dropwise to the reaction system, and reflux stirring was performed for 24 h. A saturated sodium hydrogen sulfite aqueous solution was used to quench the reaction, and a solid was precipitated, washed with water, and filtered to obtain a grey white powdery crude product; and recrystallization was performed in the dichloromethane to obtain 3.3 g of white solid powder, with a yield being 70%.

### 4. Synthesis of M4

1,4-phenylenebisboronic acid (2 g, 12 mmol), potassium carbonate (6.6 g, 48 mmol), tetrakis(triphenylphosphine)palladium (0.4 g, 0.36 mmol) were mixed in a double-necked bottle for nitrogen replacement. Ethyl 4-bromobutyrate (2.3 g, 12 mmol), 18 mL of toluene, and 12 mL of deionized water were added to the reaction system. Stirring, heating, and refluxing were performed for 24 h. The reaction was quenched in ice water, extraction was performed with the dichloromethane after water washing, the organic phase was dried with magnesium sulfate anhydrous, and then concentration and sample mixing were performed. Column chromatography separation and purification were performed, and ethyl acetate/petroleum ether was used as an eluent, and 1.98 g of a white solid product was obtained, with a yield being 70%.

### 5. Synthesis of product (I)

The M4 (3.5 g, 14.8 mmol), the M3 (2 g, 3.6 mmol), potassium carbonate (3.3 g, 24 mmol), tetrakis(triphenylphosphine)palladium (0.23 g, 0.2 mmol) were mixed in a double-necked bottle for nitrogen replacement. 18 mL of toluene and 12 mL of deionized water were added to the reaction system. Stirring, heating, and refluxing were performed for 24 h. The reaction was quenched in ice water, extraction was performed with the dichloromethane after water washing, the organic phase was dried with magnesium sulfate anhydrous, and then concentration and sample mixing were performed. Column chromatography separation and purification were performed, and ethyl acetate/petroleum ether was used as an eluent, and 2.8 g of an off-white solid product was obtained finally, with a yield being 80%.

### Embodiment 2

A light-conversion adhesive film composition included, by weight, 98.8 of parts of ethylene-vinyl acetate, 0.2 parts of a benzotriazole compound (having a structure shown in (II)), 0.5 parts of a cross-linking agent tert butyl peroxide isopropyl carbonate, and 0.5 parts of an auxiliary cross-linking agent trimethylolpropane tetraacrylate. A synthetic route of the benzotriazole derivative with the structure shown in (II) was shown as follows: 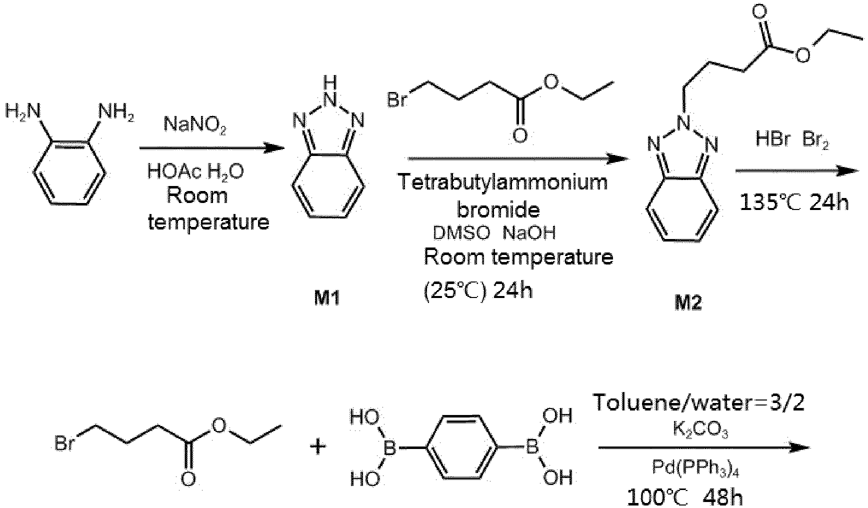 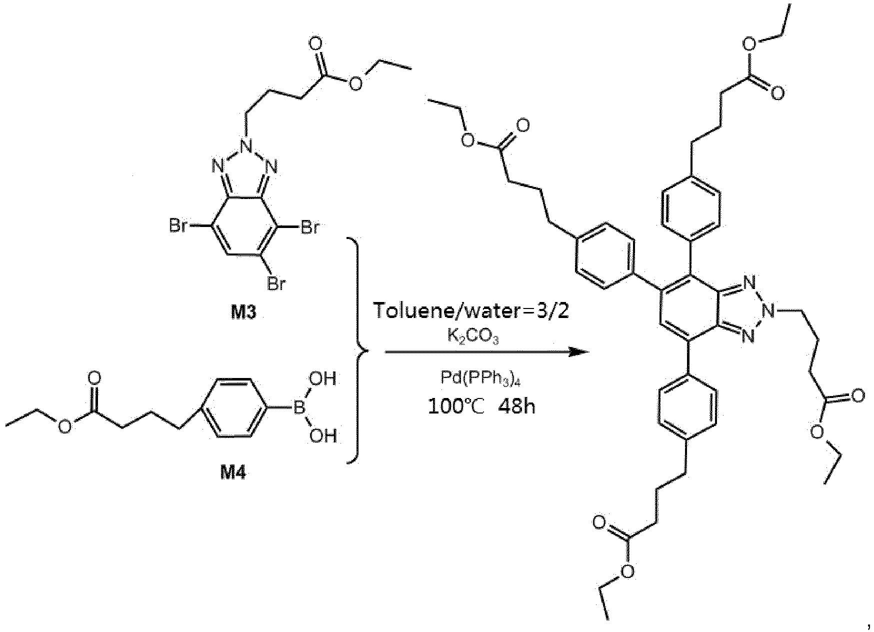 and the light-conversion adhesive film composition was well mixed, and then melt extrusion and film formation were performed at 100 °C, so as to obtain a light-conversion adhesive film.

### 1. Synthesis of M1

Same synthesis as M1 in Embodiment 1.

### 2. Synthesis of M2

Same synthesis as M2 in Embodiment 1.

### 3. Synthesis of M3

The M2 (2 g, 8.6 mmol) was dissolved in 20 mL hydrobromic acid, and heated to 100 °C. While stirring, bromine (5.5 g, 34.4 mmol) was slowly added dropwise to the reaction system, and refluxing was performed for 24 h at 120 °C. A saturated sodium hydrogen sulfite aqueous solution was used to quench the reaction, and a solid was precipitated, washed with water, and filtered to obtain a grey white powdery crude product; and recrystallization was performed in the dichloromethane to obtain 3 g of white solid powder, with a yield being 75%.

### 4. Synthesis of M4

Same synthesis as M4 in Embodiment 1.

### 5. Synthesis of product (II)

The M4 (2 g, 8.5 mmol), the M3 (1.25 g, 2.66 mmol), potassium carbonate (1.47 g, 10.6 mmol), tetrakis(triphenylphosphine)palladium (0.3 g, 0.27 mmol) were mixed in a double-necked bottle for nitrogen replacement. 18 mL of toluene and 12 mL of deionized water were added to the reaction system. Stirring, heating, and refluxing were performed for 24 h. The reaction was quenched in ice water, extraction was performed with the dichloromethane after water washing, the organic phase was dried with magnesium sulfate anhydrous, and then concentration and sample mixing were performed. Column chromatography separation and purification were performed, and ethyl acetate/petroleum ether was used as an eluent, and 1.82 g of an off-white solid product was obtained finally, with a yield being 85%.

### Embodiment 3

A difference between this embodiment and Embodiment 1 lied in that, the light-conversion agent was a benzotriazole derivative with a structure shown in (IV), of which synthetic route was shown as follows: 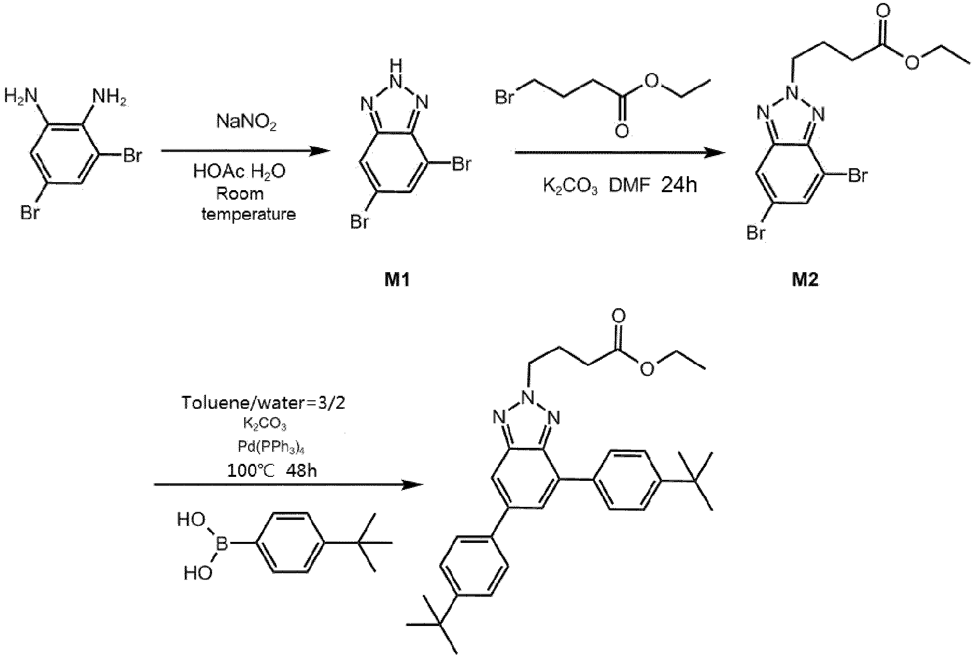 , and the light-conversion adhesive film was obtained finally.

### 1. Synthesis of M1

In a double-necked flask, 3,5-dibromo-1,2-phenylenediamine (9 g, 34 mmol) was heated to dissolve in 80 mL glacial acetic acid. While stirring, an aqueous solution (30mL) of sodium nitrite (2.76 g, 40 mmol) was slowly added dropwise. After a reaction solution was clear, stirring was continuously performed for 2 h, and the reaction was stopped. The reaction solution was placed at -10 °C for low-temperature freezing, and white solid powder was precipitated, filtered, washed with water to obtain a white crude product. 6.6 g of white powder was obtained after recrystallization, with a yield being 70%.

### 2. Synthesis of M2

A mixture of the M1 (4.65 g, 16.8 mmol), ethyl 4-bromobutyrate (3.92 g, 20 mmol), potassium carbonate (6.96 g, 50 mmol), and N,N-dimethylformamide (80 mL) was stirred under nitrogen, and heated for 2 days at 40 °C. The reaction mixture was poured in ice water and extracted with dichloromethane, an organic phase obtained through extraction was dried with magnesium sulfate anhydrous, and then vacuum distillation was performed to obtain a transparent oily droplet crude product. Column chromatography separation and purification were performed, a petroleum ether/dichloromethane mixed solvent was used as an eluent, and 3.9 g of a light yellow oily pure product was obtained finally, with a yield being 60%.

### 3. Synthesis of product (IV)

4-tert-butylphenylboronic acid (2 g, 8.5 mmol), the M2 (1.6 g, 4 mmol), potassium carbonate (3.3 g, 24 mmol), tetrakis(triphenylphosphine)palladium (0.23 g, 0.2 mmol) were mixed in a double-necked bottle for nitrogen replacement. 18 mL of toluene and 12 mL of deionized water were added to the reaction system. Stirring, heating, and refluxing were performed for 24 h. The reaction was quenched in ice water, extraction was performed with the dichloromethane after water washing, the organic phase was dried with magnesium sulfate anhydrous, and then concentration and sample mixing were performed. Column chromatography separation and purification were performed, and ethyl acetate/petroleum ether was used as an eluent, and 1.75 g of white solid powder was obtained finally, with a yield being 88%.

### Embodiment 4

A difference between this embodiment and Embodiment 1 lied in that, the light-conversion agent was the benzotriazole derivatives with the structures shown in (I) and (II), a molar ratio of the benzotriazole derivatives with the structures shown in (I) and (II) was 1:0.2, and the light-conversion adhesive film was obtained finally.

### Embodiment 5

A difference between this embodiment and Embodiment 1 lied in that, the light-conversion agent was the benzotriazole derivatives with the structures shown in (I) and (II), a molar ratio of the benzotriazole derivatives with the structures shown in (I) and (II) was 1:0.5, and the light-conversion adhesive film was obtained finally.

### Embodiment 6

A difference between this embodiment and Embodiment 1 lied in that, the light-conversion agent was the benzotriazole derivatives with the structures shown in (I) and (II), a molar ratio of the benzotriazole derivatives with the structures shown in (I) and (II) was 1:0.01, and the light-conversion adhesive film was obtained finally.

### Embodiment 7

A difference between this embodiment and Embodiment 1 lied in that, the light-conversion adhesive film composition included, by weight, 99.95 of parts of the ethylene-vinyl acetate, 0.01 parts of the benzotriazole compound with the structure shown in (II), 0.02 parts of the cross-linking agent tert butyl peroxide isopropyl carbonate, and 0.02 parts of the auxiliary cross-linking agent trimethylolpropane tetraacrylate, and the light-conversion adhesive film was obtained finally.

### Embodiment 8

A difference between this embodiment and Embodiment 1 lied in that, the light-conversion adhesive film composition included, by weight, 80 of parts of the ethylene-vinyl acetate, 10 parts of the benzotriazole compound with the structure shown in (II), 5 parts of the cross-linking agent tert butyl peroxide isopropyl carbonate, and 5 parts of the auxiliary cross-linking agent trimethylolpropane tetraacrylate, and the light-conversion adhesive film was obtained finally.

### Embodiment 9

A difference between this embodiment and Embodiment 1 lied in that, the light-conversion adhesive film composition included, by weight, 98.8 of parts of the ethylene-vinyl acetate, 0.2 parts of the benzotriazole compound (having the structure shown in (I)), 0.5 parts of the cross-linking agent tert butyl peroxide isopropyl carbonate, 0.3 parts of the auxiliary cross-linking agent trimethylolpropane tetraacrylate, and 0.2 parts of polyvinyl alcohol; the mass of hydroxyl in the polyvinyl alcohol was 0.5% of the mass of the polyvinyl alcohol; and the light-conversion adhesive film was obtained finally.

### Embodiment 10

A difference between this embodiment and Embodiment 9 lied in that, the mass of the hydroxyl in the polyvinyl alcohol was 10% of the mass of the polyvinyl alcohol, and the light-conversion adhesive film was obtained finally.

### Embodiment 11

A difference between this embodiment and Embodiment 9 lied in that, the mass of the hydroxyl in the polyvinyl alcohol was 0.1% of the mass of the polyvinyl alcohol, and the light-conversion adhesive film was obtained finally.

### Embodiment 12

A difference between this embodiment and Embodiment 9 lied in that, the mass of the hydroxyl in the polyvinyl alcohol was 20% of the mass of the polyvinyl alcohol, and the light-conversion adhesive film was obtained finally.

### Embodiment 13

A difference between this embodiment and Embodiment 9 lied in that, a polyol compound was polyethylene glycol, and the light-conversion adhesive film was obtained finally.

### Embodiment 14

A difference between this embodiment and Embodiment 1 lied in that, by weight, a matrix resin was ethylene-1-octene, and the light-conversion adhesive film was obtained finally.

### Comparative embodiment 1

A difference between this comparative embodiment and Embodiment 1 lied in that, a structural formula of the benzotriazole compound was as follows: 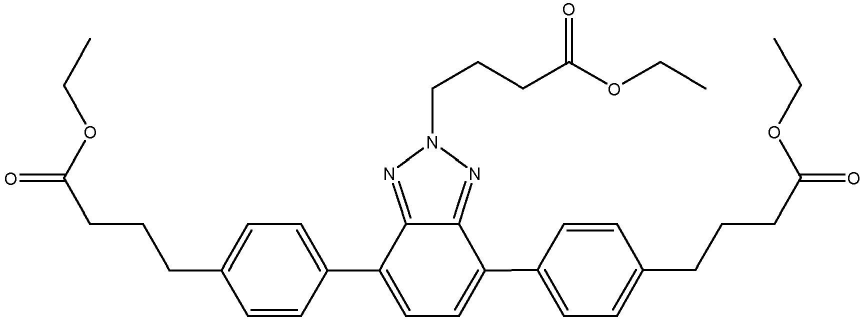 , and the light-conversion adhesive film was obtained finally.

### Comparative embodiment 2

A difference between this comparative embodiment and Embodiment 3 lied in that, by weight, the light-conversion adhesive film composition included 70 parts of a matrix resin, 15 parts of a benzotriazole compound with a structure shown in (II), and 15 parts of polyvinyl alcohol (a molecular weight being 1000, and the mass of hydroxyl in a polyol compound being 5% of the mass of the polyvinyl alcohol), the light-conversion adhesive film was obtained finally.

### Comparative embodiment 3

Coated light-conversion powder was constituted by a benzotriazole derivative organic light-conversion agent and a silicon dioxide ALD coating layer, a particle size D50 of the light-conversion agent was 10 nanometers, a specific surface area was 2000 m²/g, a thickness of the silicon dioxide coating layer was 1 nanometer, and a molecular formula of the organic light-conversion agent was shown in Formula B-1.

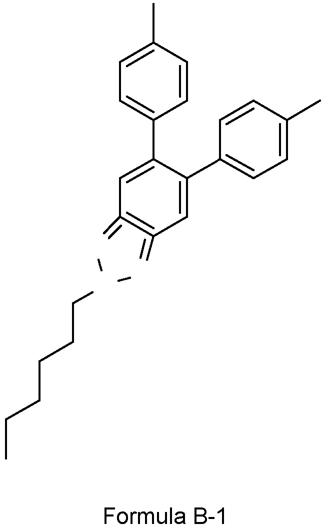

The above light-conversion powder was used to an EVA photovoltaic adhesive film; and in addition to containing 100 parts of an EVA resin and 0.05 parts of the light-conversion powder, the adhesive film also contained 0.5 parts of a peroxide cross-linking agent, 0.1 parts of an auxiliary cross-linking agent, and 0.5 parts of a silane coupling agent. Transmittance of the adhesive film within a range of 400-700 nanometers after lamination and cross-linking was 91%; the adhesive film was applied to an HJT component; initial generated power was increased 1% compared with an adhesive film having the same formula without adding the light-conversion powder; and the generated power of the component after hydrothermal aging degraded 1.3%, and the generated power after ultraviolet aging degraded 1.8%.

### Comparative embodiment 4

A difference between this comparative embodiment and Embodiment 1 lied in that, a molecular formula of the organic light-conversion agent was shown in Formula B-1.

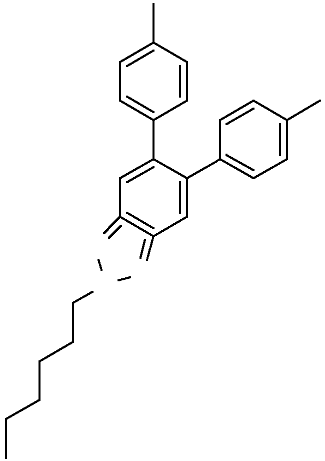

Formula B-1, and the light-conversion adhesive film was obtained finally.

### Test method

Light-conversion efficiency: a Horiba spectrometer FL-3 was used, and an absolute quantum efficiency test was performed at room temperature by using an integrating sphere.

Aging test: upper and lower surfaces of the above light-conversion adhesive films obtained in Embodiments 1 to 14 and Comparative embodiments 1 to 4 are respectively stacked with a glass layer to obtain a pre-pressing assembly, and an UV300 aging test was performed in a multi-fold UV aging oven (power being 142 W, and a temperature being 70 °C).

Yellowing index: a yellowing index (ΔYI) of the pre-pressing assembly before and after the aging test was determined according to the national standard GB2409 "Test Method for Plastic Yellow Index". The above test results were listed in Table 1.

**Table 1**

| Embodiment/Comparative embodiment | Absorption half-peak width/nm | Light-emitting efficiency/% | Stability (yellowing index ΔYI) |
|---|---|---|---|
| Embodiment 1 | 78 | 80 | 0.48 |
| Embodiment 2 | 75 | 77 | 0.53 |
| Embodiment 3 | 74 | 76 | 0.55 |
| Embodiment 4 | 76 | 79 | 0.50 |
| Embodiment 5 | 75 | 77 | 0.51 |
| Embodiment 6 | 78 | 81 | 0.48 |
| Embodiment 7 | 75 | 75 | 0.42 |
| Embodiment 8 | 76 | 77 | 0.46 |
| Embodiment 9 | 78 | 72 | 0.54 |
| Embodiment 10 | 78 | 80 | 0.49 |
| Embodiment 11 | 78 | 70 | 0.57 |
| Embodiment 12 | 78 | 74 | 0.56 |
| Embodiment 13 | 78 | 78 | 0.50 |
| Embodiment 14 | 78 | 77 | 0.60 |
| Comparative embodiment 1 | 55 | 81 | 0.54 |
| Comparative embodiment 2 | 74 | 68 | 0.59 |
| Comparative embodiment 3 | 50 | 65 | 0.61 |
| Comparative embodiment 4 | 50 | 60 | 0.66 |

It might be seen from the above description that, in the above embodiments of the present disclosure, the following technical effects were realized.

The benzotriazole derivative of the present disclosure used a benzotriazole structure as a core, the R substituent was modified at the periphery of a benzotriazole benzene ring, a D-A interaction (charge transfer excited state) in molecules was formed through a conjugation effect between the benzene rings, so as to constitute a light-emitting core. It was widely known that, in addition to intrinsic absorption (generally within 300 nm) of a group in the molecule, the absorption of D-A type organic molecule also included charge transfer transition absorption (between 300 and 400 nm) from a donor group to an acceptor group.

In the benzotriazole derivative of the present disclosure, the donor group was a peripheral R substituent, and the acceptor group was the benzotriazole located in the center of the benzotriazole derivative. Sites 4 and 7 of the benzotriazole derivative were symmetrical to each other, and sites 5 and 6 are symmetrical to each other, while Site 4 (7) and Site 5 (6) in the present disclosure were modified with the R substituents. Since the Site 4 (7) and the Site 5 (6) had different transition energy levels, two different absorption peaks but between 300 and 400 nm were generated when charge transfer transition occurs in the benzotriazole derivative, to expand an absorption range of a material in an ultraviolet region, so as to solubility and light-conversion efficiency, thereby further obtaining a wider absorption range on the basis of ensuring the light stability of a light-conversion adhesive film, such that the corresponding light-conversion adhesive film might provide better protection and beneficial effect for a battery assembly.

As analyzed in the second aspect of the Background, there was the problem of low photoelectric conversion efficiency and short service life of a photovoltaic module caused by light-conversion agent migration easily occurred in a wavelength-conversion adhesive film using a benzotriazole derivative as a light-conversion agent in the related art. In order to solve the problem, the present disclosure provided a wavelength-conversion adhesive film composition, a wavelength-conversion adhesive film, and a photovoltaic module.

A typical implementation of the present disclosure provided a wavelength-conversion adhesive film composition. The wavelength-conversion adhesive film composition included, by weight percentage, 80-99.98% of a matrix resin, 0.01-10% of a light-conversion agent, and 0.01-10% of an auxiliary agent. The light-conversion agent was a benzotriazole derivative. A structural general formula of the benzotriazole derivative was as follows.

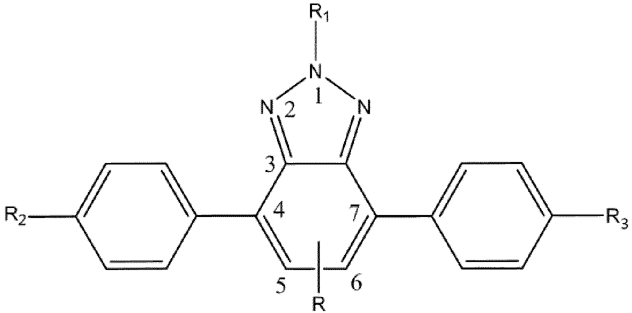

Where R₁ and R were each independently selected from any one of substituted or unsubstituted CH₂=HC-R'-*, substituted or unsubstituted C₁-C₂₀ alkyl, substituted or unsubstituted C₁-C₂₀ alkoxy, substituted or unsubstituted C₁-C₂₀ easter group, and substituted or unsubstituted C₁-C₂₀ amino, and R' is a straight bond or C₁-C₂₀ alkylene; R₂ and R₃ were each independently selected from any one of H, C₁-C₂₀ hydrocarbyl, and C₃-C₂₀ hydrocarbyl with at least one methylene substituted by -COO-; and a maximum absorption wavelength of the light-conversion agent was located between 300 and 400 nm, and a maximum emission wavelength was greater than 400 nm.

In the present disclosure, a structure of the benzotriazole derivative was optimized, and in addition to connecting an alkyl-substituted benzene ring at the Sites 4 and 7 of the benzotriazole derivative to realize molecular light-conversion performance, functional substituent groups were also connected at the Sites 5 and/or 6 of the benzotriazole derivative and a No. 2 N atom to realize the multifunctionality of the light-conversion agent. Preferably, the R, R₁, R₂, and R₃ facilitated the improvement of the solubility of the light-conversion agent in an adhesive film, such that migration and aggregation of the light-conversion agent in the adhesive film might be inhibited, and absorption and emission spectra of the light-conversion agent might be optimized according to requirements, so as to meet use requirements of assemblies from different manufacturers in different scenarios. Furthermore, even when there was a concentration difference in the light-conversion agent in the adhesive film, a migration rate of the light-conversion agent at a high temperature was greatly reduced.

In some embodiments of the present disclosure, any methylene in the above R₁ and R was substituted by any one of 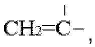 , -COO-, and -O-; preferably, R' was a straight bond or C₁-C₈ alkylene, and the R₁ and R were each independently selected from substituted or unsubstituted C₁-C₈ alkyl, substituted or unsubstituted C₁-C₈ alkoxy, substituted or unsubstituted C₁-C₈ ester group, and substituted or unsubstituted C₁-C₈ amino; preferably, the R₁ and R were each independently selected from any one of C₁-C₈ straight chain alkyl, C₃-C₈ branched alkyl, and C₁-C₈ alkoxy; preferably, the R₁ and R were each independently selected from any one of methyl, methoxy, ethyl, ethoxy, propyl, propoxy, butyl, butoxyl, pentyl, pentyloxy, hexyl, hexyloxy, heptyl, heptyloxy, octyl, octyloxy, vinyl, allyl, alkenylbutyl, alkenylpentyl, alkenylhexyl, alkenylheptyl, alkenyloctyl, 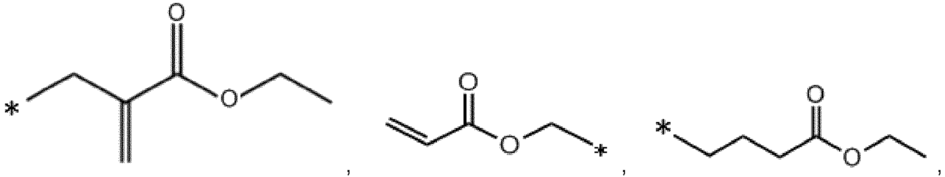 and 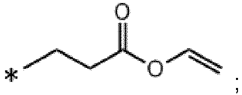 and further preferably, the R₁ and R were each independently selected from any one of alkenyloctyl, heptyl,

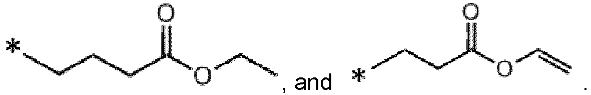

Preferably, the R₁ and R were more conductive to improving the solubility of the adhesive film in the matrix resin, and facilitated a reduction of aggregation of the light-conversion agent.

In some embodiments of the present disclosure, the R₁ and R respectively were substituents capped with unsaturated substituted functional groups, preferably, the unsaturated substituted functional group was selected from any one of alkenyl hydrocarbyl, an acrylic group, and an acrylate group; preferably, the unsaturated substituted functional group was vinyl; and/or when the R₁ and R have substituents, the substituent was selected from any one or more of methyl, ethyl, propyl, butyl, trifluoromethyl, and nitro.

Preferably, when the R₁ and R respectively were substituents capped with unsaturated substituted functional groups, the unsaturated bonds therein cross-linked with the substrate in the wavelength-conversion adhesive film to immobilize the light-conversion agent molecules, thereby inhibiting the aggregation and migration of the light-conversion agent molecules in the wavelength-conversion adhesive film.

In some embodiments of the present disclosure, the above R₂ and the R₃ were each independently selected from any one or more of H, C₁-C₁₀ hydrocarbyl, and C₃-C₁₀ hydrocarbyl with at least one methylene substituted by -COO-, and preferably, the R₂ and the R₃ were each independently selected from any one or more of 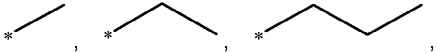 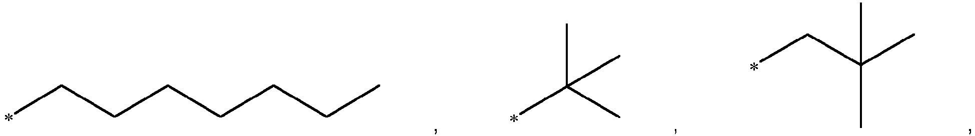 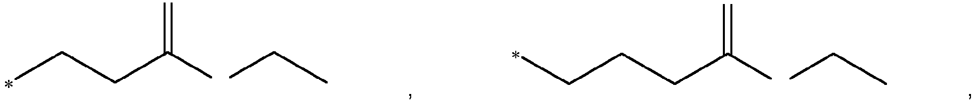 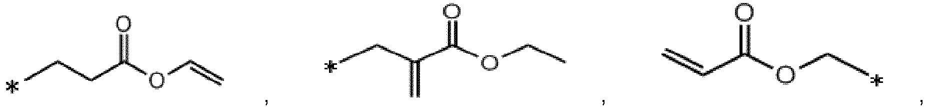 and 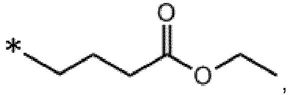 where "*" indicated connection sites of the R₂ and the R₃ on benzene rings on which they were located.

Preferably, the substituents R₂ and R₃ were more conductive to improving the compatibility between the light-conversion agent and the matrix resin in the wavelength-conversion adhesive film, thereby providing a more favorable protective layer to the light-emitting core structure.

In order to further improve the performance such as light stability, light-conversion efficiency, etc. of the light-conversion agent, preferably, the above benzotriazole derivative is selected from any one or more of 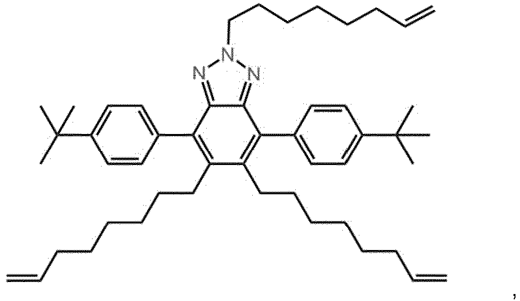 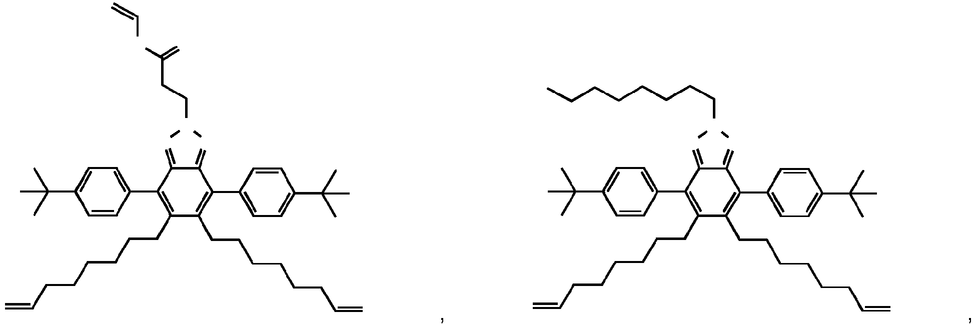 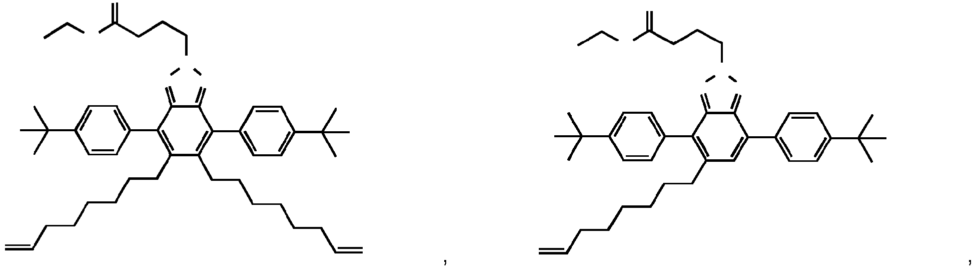 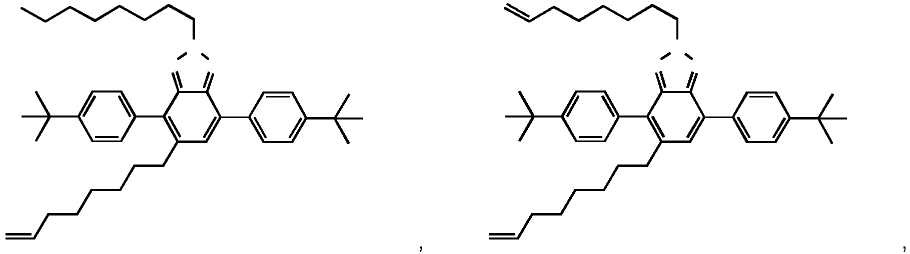 and 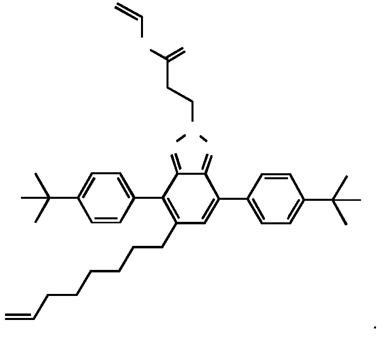 Preferably, the R₂ and R₃ were tert-butyl, such that the probability of molecular planarization was reduced, thereby effectively reducing the possible π-π quenching fluorescence phenomenon.

In an embodiment of the present disclosure, the above auxiliary agent included a cross-linking agent and/or an auxiliary cross-linking agent; and preferably, a weight percentage of the cross-linking agent was 0.005-5%, and/or a weight percentage of the auxiliary cross-linking agent was 0.005-5%.

The cross-linking agent was a molecule having a plurality of olefinic unsaturated groups, which might promote the cross-linking of polymers, thereby achieving a higher degree of cross-linking. The cross-linking agent in the above composition might be selected from those commonly used in the art. Preferably, the cross-linking agent was selected from any one or more of tert butyl peroxide isopropyl carbonate, 2,5-dimethyl-2,5-di(tert-butylperoxy)hexane, tert-butylperoxy 2-ethylhexyl carbonate, 1,1-di-(tert-butylperoxy)-3,3,5-trimethylcyclohexane, 1,1-bis(tert-amylperoxy)-3,3,5-trimethylcyclohexane, 1,1-bis(tert-amylperoxy)cyclohexane, 1, 1-di(tert-butylperoxy)cyclohexane, 2,2-bis(tert-butylperoxy)butane, tert-amylperoxy 2-ethylhexyl carbonate, 2,5-dimethyl-2,5-dimethyl-2,5-dimethyl-di-(benzoyl peroxy) hexane, tert amyl peroxycarbonate, and tert-butyl peroxy-3,3,5-trimethylhexanoate. Preferably, the auxiliary cross-linking agent was selected from any one or more of triallyl isocyanurate, triallyl cyanurate, trimethylolpropane triacrylate, trimethylolpropane trimethacrylate, pentaerythritol triacrylate, isocyanuric acid tris(2-acryloyloxyethyl) ester, ethoxylated trimethylolpropane triacrylate, trimethylolpropane triacrylate, ethoxylated glycerol triacrylate, glyceryl propoxy triacrylate, pentaerythritol tetraacrylate, ethoxylated pentaerythitol tetraacrylate, trimethylolpropane tetraacrylate, di(trimethylolpropane) tetraacrylate, bis(trimethylolpropane) tetramethylacrylate, propoxylated pentaerythritol tetra-acrylate, 2,4,6-tris(2-propenyloxy)-1,3,5-triazine, tricyclic cyclohexane dimethanol diacrylate, propylene oxide neopentyl glycol diacrylate, ethoxylated (10) bisphenol A diacrylate, ethoxylated bisphenol A dimethacrylate, 2-butyl-2-ethyl-1,3-propylene glycol diacrylate, diethylene glycol dimethacrylate, triethylene glycol dimethacrylate, and poly(ethylene glycol) dimethacrylate.

In an embodiment of the present disclosure, the above auxiliary agent further included a polyol compound; preferably, the mass of hydroxyl in the polyol compound was 0.1-20% of the mass of the polyol compound, preferably 0.5-10%; preferably, a molecular weight of the polyol compound was 500-80000; and preferably, the polyol compound was selected from any one or more of a polyvinyl alcohol compound, polyethylene glycol, and polypropylene glycol.

The benzotriazole derivative was not very compatible with the matrix resin due to its high rigidity. An alkyl main chain of the polyol compound auxiliary agent had a component similar to the matrix resin, and a hydrogen bond was formed by a hydroxyl functional group contained in a side chain of the polyol compound auxiliary agent and an ester functional group of the light-conversion agent. Preferably, the content of the hydroxyl in the polyol compound was within the above range, the compatibility of the light-conversion agent and the matrix resin was improved, such that the compatibility of the light-conversion agent and the matrix resin was further improved under the dual action of similar compatibility and hydrogen bonding.

In an embodiment of the present disclosure, the above auxiliary agent further included a thickening agent. The addition of the thickening agent might improve the adhesion between the adhesive film and a substrate. In a preferred embodiment, the thickening agent included, but is limited to, one or more of a group consisting of γ-aminopropyltriethoxysilane, γ-Methacryloyloxypropyl trimethoxysilane, γ-(2,3-epoxypropoxy)propyltrimethoxysilane, vinyltrimethoxysilane, n-β-(aminoethyl)-γ-aminopropyltrimethoxysilane, γ-glycidyloxypropyltrimethoxysilane, and 3-aminopropyltrimethylsilane.

In some embodiments of the present disclosure, preferably, the above matrix resin was selected from any one or more of EVA, PVA, PMMA, POE, and organosilicon, and thus better cooperated with components such as the light-conversion agent, so as to obtain the light-conversion adhesive film with excellent performance. The above matrix resin was cheap in price, facilitating reduction in cost. Definitely, other base resins might be used by those skilled in the art and are not described herein again.

In an embodiment of the present disclosure, based on a total mass of the above matrix resin, light-conversion agent, and auxiliary agent being 100%, the wavelength-conversion adhesive film composition further included 0.01-1% of a cross-linking agent, preferably 0.01-0.5%.

Preferably, the foregoing light-conversion agent was conductive to synergizing with the cross-linking agent, so as to improve the cross-linking effect of the cross-linking agent thereby improving the performance of the wavelength-conversion adhesive film.

Another typical implementation of the present disclosure provided a wavelength-conversion adhesive film, which was prepared by mixing and molding an adhesive film composition. The adhesive film composition was the foregoing wavelength-conversion adhesive film composition.

In some preferred embodiments of the present disclosure, after the foregoing wavelength-conversion adhesive film composition was well mixed, the wavelength-conversion adhesive film was obtained through preparation using preparation processes such as melt extrusion molding at 80-120 °C. The obtained wavelength-conversion adhesive film had excellent stability and high light-emitting efficiency, and might be effective for a long time, thereby improving the service life of a photovoltaic apparatus.

Another typical implementation of the present disclosure provided a photovoltaic module, including a light-conversion adhesive film. The light-conversion adhesive film was the above wavelength-conversion adhesive film.

The photovoltaic module including the above wavelength-conversion adhesive film of the present disclosure had excellent light-conversion efficiency. Definitely, there might be more choices according to different requirements and application scenarios. The wavelength-conversion adhesive film of the present disclosure was not limited to a photovoltaic apparatus, an agricultural film, architectural glass, and other fields.

The beneficial effects of the present disclosure were further described below with reference to the embodiments.

### Embodiment 1

A light-conversion adhesive film composition included, by weight, 98.8 of parts of ethylene-vinyl acetate, 0.5 parts of a benzotriazole compound (having a structure shown in (I)), 0.5 parts of a cross-linking agent tert butyl peroxide isopropyl carbonate, and 0.2 parts of an auxiliary cross-linking agent trimethylolpropane tetraacrylate. A synthetic route of the benzotriazole derivative with the structure shown in (I) was shown as follows:

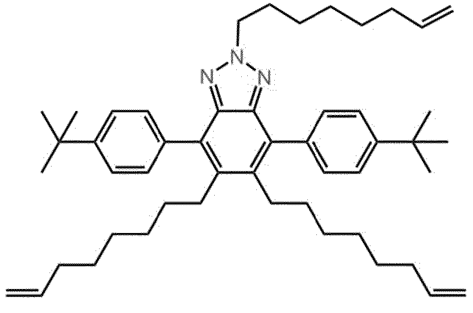

### Benzotriazole derivative 1

The synthetic route of Embodiment 1 was shown as follows.

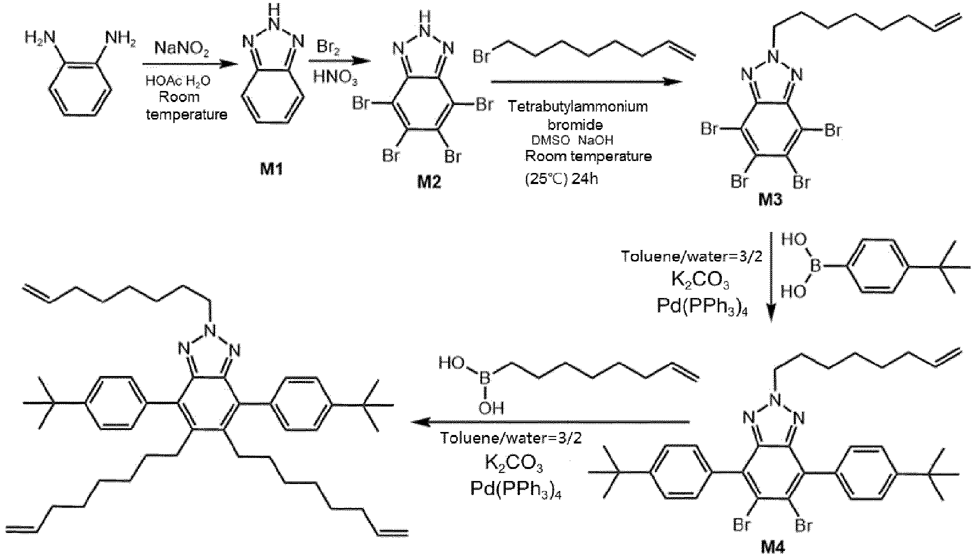

### 1. Synthesis of M1

In a double-necked flask, o-phenylenediamine (3.67 g, 34 mmol) was heated to dissolve in 60 mL glacial acetic acid. While stirring, an aqueous solution (30mL) of sodium nitrite (2.76 g, 40 mmol) was slowly added dropwise. After a reaction solution was clear, stirring was continuously performed for 2 h, and the reaction was stopped. The reaction solution was placed at -10 °C for low-temperature freezing, and white solid powder was precipitated, filtered, washed with water to obtain a white crude product. 3 g of pure white crystalline powder was obtained after recrystallization, with a yield being 75%.

### 2. Synthesis of M2

The M1 (2 g, 16.8 mmol) was dissolved in 20 mL nitric acid, and heated. While stirring, bromine (13.5 g, 84 mmol) was slowly added dropwise to the reaction system, and reflux stirring was performed for 24 h. A saturated sodium hydrogen sulfite aqueous solution was used to quench the reaction, and a solid was precipitated, washed with water, and filtered to obtain a grey white powdery crude product; and recrystallization was performed in ethanol to obtain 4.7 g of white solid powder, with a yield being 65%.

### 3. Synthesis of M3

A mixture of the M2 (2 g, 4.6 mmol), 8-bromo-1-octene (1.1 g, 5.6 mmol), potassium carbonate (1.95 g, 14 mmol), and N,N-dimethylformamide (20 mL) was stirred under nitrogen, and heated for 2 days at 40 °C. The reaction mixture was poured in ice water and extracted with dichloromethane, an organic phase obtained through extraction was dried with magnesium sulfate anhydrous, and then vacuum distillation was performed to obtain a transparent oily droplet crude product. Column chromatography separation and purification were performed, a petroleum ether/dichloromethane mixed solvent was used as an eluent, and 1.6 g of a light yellow oily pure product was obtained finally, with a yield being 64%.

### 4. Synthesis of M4

The M3 (2 g, 3.6 mmol), the 4-tert-Butylphenylboronic acid (1.35 g, 7.6 mmol), potassium carbonate (3.3 g, 24 mmol), tetrakis(triphenylphosphine)palladium (0.2 g, 0.18 mmol) were mixed in a double-necked bottle for nitrogen replacement. 18 mL of toluene and 12 mL of deionized water were added to the reaction system. Stirring, heating, and refluxing were performed for 24 h. The reaction was quenched in ice water, extraction was performed with the dichloromethane after water washing, the organic phase was dried with magnesium sulfate anhydrous, and then concentration was performed to obtain a light yellow oily crude product.

### 5. Synthesis of benzotriazole derivative 1

The M4 crude product, the 7-enyloctylboronic acid (1.2 g, 7.6 mmol), potassium carbonate (3.3 g, 24 mmol), tetrakis(triphenylphosphine)palladium (0.2 g, 0.18 mmol) were mixed in a double-necked bottle for nitrogen replacement. 18 mL of toluene and 12 mL of deionized water were added to the reaction system. Stirring, heating, and refluxing were performed for 24 h. The reaction was quenched in ice water, extraction was performed with the dichloromethane after water washing, the organic phase was dried with magnesium sulfate anhydrous, and then concentration and sample mixing were performed. Dichloromethane/petroleum ether was used as an eluent, and 1.8 g of pure white solid powder was obtained through column chromatography separation, with a yield being 70%.

### Embodiment 2

A light-conversion adhesive film composition included, by weight, 98.8 of parts of ethylene-vinyl acetate, 0.5 parts of a benzotriazole compound (having a structure shown in (II)), 0.5 parts of a cross-linking agent tert butyl peroxide isopropyl carbonate, and 0.2 parts of an auxiliary cross-linking agent trimethylolpropane tetraacrylate. A synthetic route of the benzotriazole derivative with the structure shown in (II) was shown as follows:

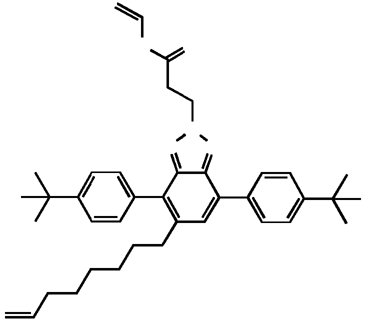

### Benzotriazole derivative 2

The synthetic route of Embodiment 2 was shown as follows.

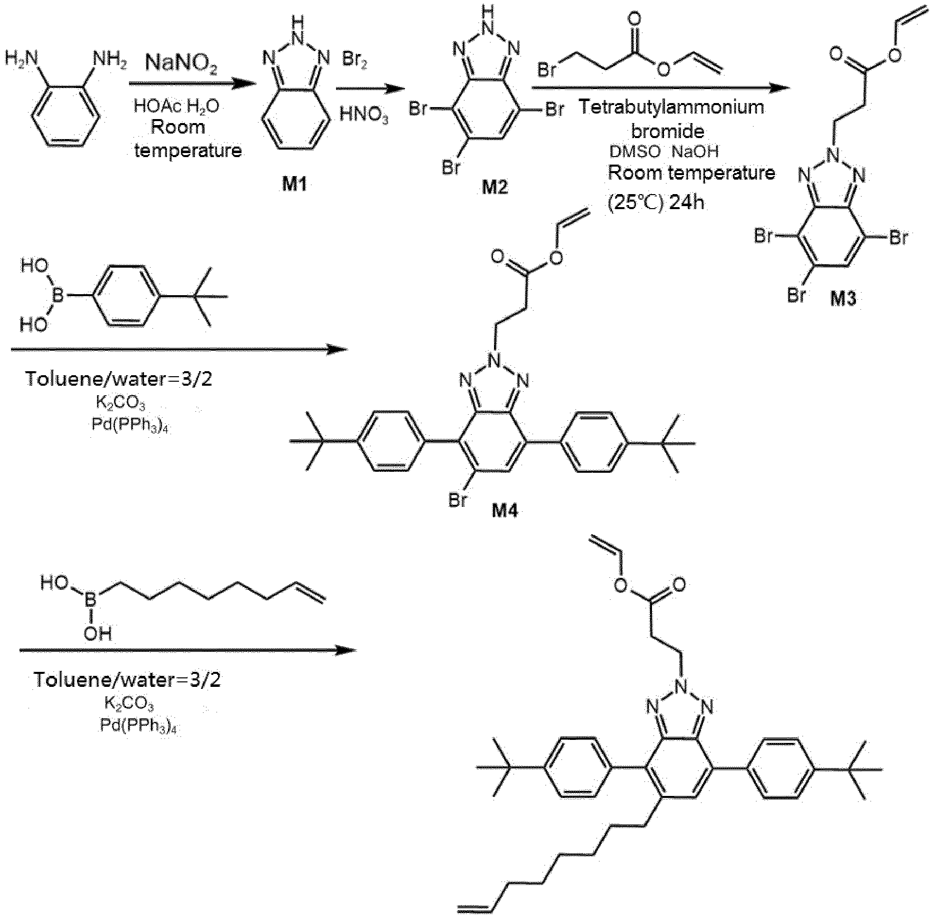

### 1. Synthesis of M1

Same synthesis as M1 in Embodiment 1

### 2. Synthesis of M2

The M1 (2 g, 16.8 mmol) was dissolved in 20 mL nitric acid, and heated. While stirring, bromine (10.7 g, 67.2 mmol) was slowly added dropwise to the reaction system, and reflux stirring was performed for 24 h. A saturated sodium hydrogen sulfite aqueous solution was used to quench the reaction, and a solid was precipitated, washed with water, and filtered to obtain a grey white powdery crude product; and recrystallization was performed in ethanol to obtain 3.6 g of white solid powder, with a yield being 60%.

### 3. Synthesis of M3

A mixture of the M2 (2 g, 5.6 mmol), 2-bromoethyl acrylate (1.2 g, 6.7 mmol), potassium carbonate (2.3 g, 16.8 mmol), and N,N-dimethylformamide (20 mL) was stirred under nitrogen, and heated for 2 days at 40 °C. The reaction mixture was poured in ice water and extracted with dichloromethane, an organic phase obtained through extraction was dried with magnesium sulfate anhydrous, and then vacuum distillation was performed to obtain a transparent oily droplet crude product. Column chromatography separation and purification were performed, a petroleum ether/dichloromethane mixed solvent was used as an eluent, and 1.5 g of a light yellow solid pure product was obtained finally, with a yield being 60%.

### 4. Synthesis of M4

The M3 (2 g, 4.4 mmol), the 4-tert-Butylphenylboronic acid (1.65 g, 9.3 mmol), potassium carbonate (3.3 g, 24 mmol), tetrakis(triphenylphosphine)palladium (0.25 g, 0.22 mmol) were mixed in a double-necked bottle for nitrogen replacement. 18 mL of toluene and 12 mL of deionized water were added to the reaction system. Stirring, heating, and refluxing were performed for 24 h. The reaction was quenched in ice water, extraction was performed with the dichloromethane after water washing, the organic phase was dried with magnesium sulfate anhydrous, and then concentration was performed to obtain a light yellow oily crude product.

### 5. Synthesis of benzotriazole derivative 2

The M4 crude product, the 7-enyloctylboronic acid (0.83 g, 5.3 mmol), potassium carbonate (2.8 g, 20 mmol), tetrakis(triphenylphosphine)palladium (0.13 g, 0.11 mmol) were mixed in a double-necked bottle for nitrogen replacement. 15 mL of toluene and 10 mL of deionized water were added to the reaction system. Stirring, heating, and refluxing were performed for 24 h. The reaction was quenched in ice water, extraction was performed with the dichloromethane after water washing, the organic phase was dried with magnesium sulfate anhydrous, and then concentration and sample mixing were performed. Dichloromethane/petroleum ether was used as an eluent, and 1.95 g of pure white solid powder was obtained through column chromatography separation, with a yield being 75%.

### Embodiment 3

A difference between this embodiment and Embodiment 1 lied in that, the wavelength-conversion adhesive film composition included, by weight, 99.95 of parts of the ethylene-vinyl acetate, 0.01 parts of the benzotriazole compound with the structure shown in Embodiment 1, 0.02 parts of the cross-linking agent tert butyl peroxide isopropyl carbonate, and 0.02 parts of the auxiliary cross-linking agent trimethylolpropane tetraacrylate, and the wavelength-conversion adhesive film was obtained finally.

### Embodiment 4

A difference between this embodiment and Embodiment 1 lied in that, the wavelength-conversion adhesive film composition included, by weight, 80 of parts of the ethylene-vinyl acetate, 10 parts of the benzotriazole compound with the structure shown in Embodiment 1, 5 parts of the cross-linking agent tert butyl peroxide isopropyl carbonate, and 5 parts of the auxiliary cross-linking agent trimethylolpropane tetraacrylate, and the wavelength-conversion adhesive film was obtained finally.

### Embodiment 5

A difference between this embodiment and Embodiment 1 lied in that, the wavelength-conversion adhesive film composition included, by weight, 98.8 of parts of the ethylene-vinyl acetate, 0.2 parts of the benzotriazole compound in Embodiment 2, 0.5 parts of the cross-linking agent tert butyl peroxide isopropyl carbonate, 0.3 parts of the auxiliary cross-linking agent trimethylolpropane tetraacrylate, and 0.2 parts of polyvinyl alcohol; the mass of hydroxyl in the polyvinyl alcohol was 0.5% of the mass of the polyvinyl alcohol; and the wavelength-conversion adhesive film was obtained finally.

### Embodiment 6

A difference between this embodiment and Embodiment 5 lied in that, the mass of the hydroxyl in the polyvinyl alcohol was 10% of the mass of the polyvinyl alcohol, and the wavelength-conversion adhesive film was obtained finally.

### Embodiment 7

A difference between this embodiment and Embodiment 5 lied in that, the mass of the hydroxyl in the polyvinyl alcohol was 0.1% of the mass of the polyvinyl alcohol, and the wavelength-conversion adhesive film was obtained finally.

### Embodiment 8

A difference between this embodiment and Embodiment 5 lied in that, the mass of the hydroxyl in the polyvinyl alcohol was 20% of the mass of the polyvinyl alcohol, and the wavelength-conversion adhesive film was obtained finally.

### Embodiment 9

A difference between this embodiment and Embodiment 5 lied in that, a polyol compound was polyethylene glycol, and the wavelength-conversion adhesive film was obtained finally.

### Embodiment 10

A difference between this embodiment and Embodiment 1 lied in that, by weight, a matrix resin was ethylene-1-octene, and the wavelength-conversion adhesive film was obtained finally.

### Comparative embodiment 1

A difference between this comparative embodiment and Embodiment 1 lied in that, a structural formula of the benzotriazole compound was as follows: 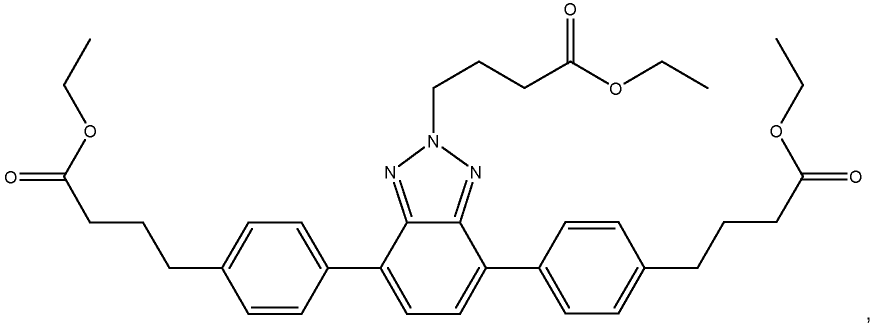 and the wavelength-conversion adhesive film was obtained finally.

### Comparative embodiment 2

A difference between this comparative embodiment and Embodiment 1 lied in that, by weight, the wavelength-conversion adhesive film composition included 70 parts of a matrix resin, 15 parts of the benzotriazole compound with a structure shown in Embodiment 1, and 15 parts of polyvinyl alcohol (a molecular weight being 1000, and the mass of hydroxyl in a polyol compound being 5% of the mass of the polyvinyl alcohol), the wavelength-conversion adhesive film was obtained finally.

### Comparative embodiment 3

Coated light-conversion powder was constituted by a benzotriazole derivative organic light-conversion agent and a silicon dioxide ALD coating layer, a particle size D50 of the light-conversion agent was 10 nanometers, a specific surface area was 2000 m²/g, a thickness of the silicon dioxide coating layer was 1 nanometer, and a molecular formula of the organic light-conversion agent was shown in Formula B-1.

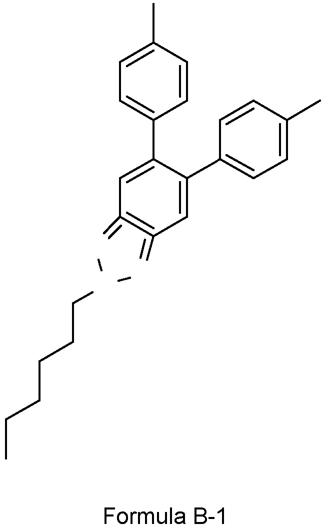

The above light-conversion powder was used to an EVA photovoltaic adhesive film; and in addition to containing 100 parts of an EVA resin and 0.05 parts of the light-conversion powder, the adhesive film also contained 0.5 parts of a peroxide cross-linking agent, 0.1 parts of an auxiliary cross-linking agent, and 0.5 parts of a silane coupling agent. Transmittance of the adhesive film within a range of 400-700 nanometers after lamination and cross-linking was 91%; the adhesive film was applied to an HJT component; initial generated power was increased 1% compared with an adhesive film having the same formula without adding the light-conversion powder; and the generated power of the component after hydrothermal aging degraded 1.3%, and the generated power after ultraviolet aging degraded 1.8%.

### Comparative embodiment 4

A difference between this comparative embodiment and Embodiment 1 lied in that, a molecular formula of the organic light-conversion agent was shown in Formula B-1.

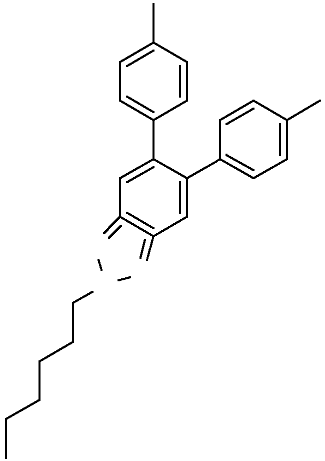

Formula B-1, and the wavelength-conversion adhesive film was obtained finally.

### Test method

Light-conversion efficiency: a Horiba spectrometer FL-3 was used, and an absolute quantum efficiency test was performed at room temperature by using an integrating sphere.

Aging test: upper and lower surfaces of the wavelength-conversion adhesive films obtained in the above embodiments and comparative embodiments are respectively stacked with a glass layer to obtain a pre-pressing assembly, and an UV300 aging test was performed in a multi-fold UV aging oven (power being 142 W, and a temperature being 70 °C). Yellowing index: a yellowing index (ΔYI) of the pre-pressing assembly before and after the aging test was determined according to the national standard GB2409 "Test Method for Plastic Yellow Index".

Migration rate test method: a rapid aging migration test was performed on an assembly end, a front surface of a photovoltaic module was a wavelength light-conversion film mixed with the light-conversion agent, a back surface of the module was a blank film (only the conversion agent being a variable) without the light-conversion agent, the module was subjected to the UV300 aging test in an aging oven, and then the adhesive film on the front surface of the module was dismantled respectively for heating soaking treatments (stirring, heating, and soaking at 60 °C for 24 h) with an organic solvent (methanol). HPLC analysis was performed on the solution after soaking, so as to obtain one content (A) in Embodiment 1. The adhesive film of the front side of the module that had not been aged was removed for the same heating soaking treatments, and HPLC analysis was performed on the solution after soaking, so as to obtain another content (B) in Embodiment 1. Migration rate was A/B*100%.

The above test results were listed in Table 1.

**Table 1**

| Embodiment/Comparative embodiment | Light-conversion efficiency/% | Stability (yellowing index ΔYI) | Migration rate/% |
|---|---|---|---|
| Embodiment 1 | 86.6 | 0.51 | 0.05 |
| Embodiment 2 | 85.7 | 0.53 | 0.08 |
| Embodiment 3 | 82.8 | 0.48 | 0.01 |
| Embodiment 4 | 85.5 | 0.58 | 0.25 |
| Embodiment 5 | 84.6 | 0.45 | 0.06 |
| Embodiment 6 | 84.1 | 0.42 | 0.05 |
| Embodiment 7 | 83.2 | 0.53 | 0.10 |
| Embodiment 8 | 83.7 | 0.44 | 0.09 |
| Embodiment 9 | 84.9 | 0.46 | 0.08 |
| Embodiment 10 | 86.2 | 0.53 | 2.3 |
| Comparative embodiment 1 | 86.8 | 0.50 | 6.7 |
| Comparative embodiment 2 | 80.3 | 0.55 | 0.56 |
| Comparative embodiment 3 | 62.3 | 0.64 | 8.4 |
| Comparative embodiment 4 | 58.4 | 0.72 | 7.6 |

It might be seen from the above description that, in the above embodiments of the present disclosure, the following technical effects were realized.

In the present disclosure, a structure of the benzotriazole derivative was optimized, and in addition to connecting an alkyl-substituted benzene ring at the Sites 4 and 7 of the benzotriazole derivative to realize molecular light-conversion performance, functional substituent groups were also connected at the Sites 5 and/or 6 of the benzotriazole derivative and a No. 2 N atom to realize the multifunctionality of the light-conversion agent. Preferably, the R, R₁, R₂, and R₃ facilitated the improvement of the solubility of the light-conversion agent in an adhesive film, such that migration and aggregation of the light-conversion agent in the adhesive film might be inhibited, and absorption and emission spectra of the light-conversion agent might be optimized according to requirements, so as to meet use requirements of assemblies from different manufacturers in different scenarios. Furthermore, even when there was a concentration difference in the light-conversion agent in the adhesive film, a migration rate of the light-conversion agent at a high temperature was greatly reduced.

As analyzed in the third aspect of the Background, there was the problem of low photoelectric conversion efficiency, poor stability, and short service life of conventional adhesive films in the related art. In order to solve the problem, the present disclosure provided a light-conversion adhesive film composition, a light-conversion adhesive film, and a photovoltaic module.

A typical implementation of the present disclosure provided a light-conversion adhesive film composition. The light-conversion adhesive film composition included, by weight percentage, 80%-99.98% of a matrix resin, 0.01%-10% of a light-conversion agent, and 0.01%-10% of an auxiliary agent. The light-conversion agent was a benzotriazole compound. A structural general formula of the benzotriazole compound was as follows.

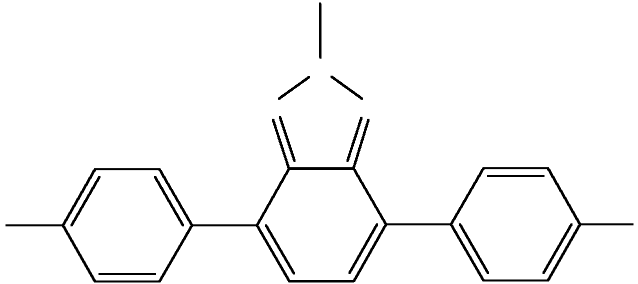

R₁ was C₃-C₂₀ alkyl with at least one methylene substituted by -COO-, and R₂ and R₃ were each independently selected from any one or more of H, C₁-C₂₀ alkyl, and C₃-C₂₀ alkyl with at least one methylene substituted by -COO-; and the auxiliary agent included a polyol compound.

The ester group contained in the R₁ at the No. 2 N position of benzotriazole provided a first protective layer for the benzotriazole light-emitting core. Moreover, the ester group having an oxygen atom might also form an interaction such as a hydrogen bond with the matrix resin to improve the compatibility of the light-conversion agent and the matrix resin, thereby providing a second protective layer to the light-emitting core structure. The benzotriazole compound was not very compatible with the matrix resin due to its high rigidity. An alkyl main chain of the polyol compound auxiliary agent had a component similar to the matrix resin, and a hydrogen bond was formed by a hydroxyl functional group contained in a side chain of the polyol compound auxiliary agent and an ester functional group of the light-conversion agent, such that the compatibility of the light-conversion agent and the matrix resin was improved under the dual action of similar compatibility and hydrogen bonding, and the protection effect of the matrix resin to the light-conversion agent was achieved at the same time, so as to provide a third protective layer for the light-emitting core structure, thereby improving the stability of the light-conversion agent under the above multiple protective effects, and optimizing a film formation effect. Furthermore, the motion of the light-conversion agent inside the matrix resin was further limited due to the effect of the hydrogen bond, an energy loss during molecular luminescence was reduced, the rigidity of molecules in the light-conversion agent was improved, and the purpose of light-conversion efficiency was improved finally. Therefore, the light-conversion adhesive film obtained by using the light-conversion adhesive film composition of the present disclosure had excellent light stability and high light-emitting efficiency, and might be effective for a long time, thereby improving the service life of a photovoltaic apparatus.

In an embodiment of the present disclosure, the above light-conversion adhesive film composition included, by weight percentage, 98%-99.98% of the matrix resin, 0.01%-1% of the light-conversion agent, and 0.01%-1% of the auxiliary agent; and further preferably, a mass ratio of the above light-conversion agent to the auxiliary agent is 1:2-500, preferably 1:2-50.

Preferably, the content of the above light-conversion adhesive film composition contributed to a fuller utilization of the components and improved the overall collaborative cooperation effect of the components. Preferably, the above mass ratio of the light-conversion agent and auxiliary agent was conductive to giving full play to the synergistic effect of the light-conversion agent and auxiliary agent, thus improving the compatibility between the light-conversion agent and the matrix resin.

In an embodiment of the present disclosure, the mass of hydroxyl in the polyol compound was 0.1-20% of the mass of the polyol compound, preferably 0.5-10%; preferably, a molecular weight of the polyol compound was 500-80000, for example, 500, 1000, 1500, 2000, 3000, 4000, 5000, 10000, 20000, 30000, 40000, 50000, 60000, 70000, or 80000; and preferably, the polyol compound was selected from any one or more of a polyvinyl alcohol compound, polyethylene glycol, and polypropylene glycol.

If the amount of the hydroxyl in the polyol compound was too much, the water vapor barrier property of the light-conversion adhesive film was reduced. Preferably, the above polyol compound auxiliary agent helped the hydroxyl functional group to form an appropriate amount of hydrogen bonds with the ester functional group of the light-conversion agent, such that the compatibility between the light-conversion agent and the matrix resin was improved, the stability of the light-conversion agent was improved, a film formation effect was optimized, and the molecular rigidity of the light-conversion agent was improved, thereby improving light-conversion efficiency.

In an embodiment of the present disclosure, the above auxiliary agent further included a polyester compound; preferably, a molecular weight of the polyester compound was 500-80000; preferably, a mass ratio of the polyol compound to the polyester compound was 1:0.01-1; preferably, the mass ratio of the polyol compound to the polyester compound was 1:0.1-0.5; preferably, the polyester compound was aliphatic polyester and/or aromatic polyester; preferably, the aromatic polyester was polyethylene terephthalate; preferably, the aliphatic polyester was selected from any one or more of a polyester compound obtained through polymerization of C₂-C₁₂ aliphatic diprotic acid and C₂-C₁₂ alkyl dihydric alcohol, and polyurethane; and preferably, the aliphatic polyester was selected from any one or more of polyurethane, poly butylenes succinate, poly(methyl methacrylate), polyethylene glycol ester, and polyhydroxybutyrate.

While the hydrogen bond was formed between the polyol compound and the light-conversion agent, the remaining hydroxyl in the polyol compound might form the hydrogen bond with an oxygen atom on the polyester compound, and the compatibility between the light-conversion agent and the matrix resin was indirectly improved by using the components of the alkyl main chain of the polyol compound similar to those of the matrix resin. Furthermore, the addition of the polyester compound reduced the addition of the polyol compound, thereby effectively solving the problem of reduced water vapor barrier property of the light-conversion adhesive film caused by excessive hydroxyl in the polyol compound. Preferably, the above polyester compound and the molecular weight thereof such as 500, 1000, 1500, 2000, 3000, 4000, 5000, 10000, 20000, 30000, 40000, 50000, 60000, 70000, or 80000, as well as the mass ratio of the polyol compound, were conductive to improving the synergistic effect of the polyester compound and the polyol compound, such that the light-conversion adhesive film had good water vapor barrier property while the light-conversion agent and the matrix resin had excellent compatibility.

In some embodiments of the present disclosure, preferably, the above R₁ was C₃-C₁₀ alkyl with at least one methylene substituted by -COO-, and preferably, the R₁ was selected from any one or more of 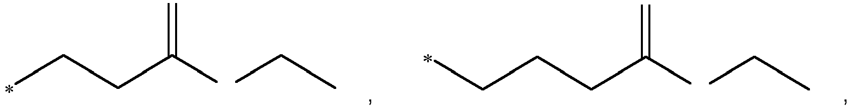 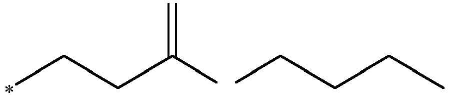 and 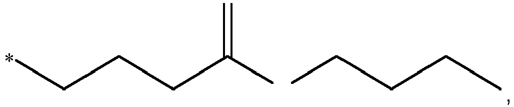 where "*" indicated a connection site of the benzotriazole compound with the R₁ except the portion of the R₁.

Preferably, the above types of ester groups were conductive to better forming an interaction such as a hydrogen bond with the matrix resin, thereby improving the compatibility of the light-conversion agent and the matrix resin, and providing a strong protection effect to the light-emitting core structure.

In some embodiments of the present disclosure, preferably, the above R₂ and the R₃ were each independently selected from any one or more of H, C₁-C₁₀ alkyl, and C₃-C₁₀ alkyl with at least one methylene substituted by -COO-, and preferably, the R₂ and the R₃ were each independently selected from any one or more of 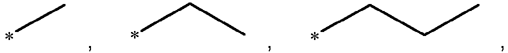 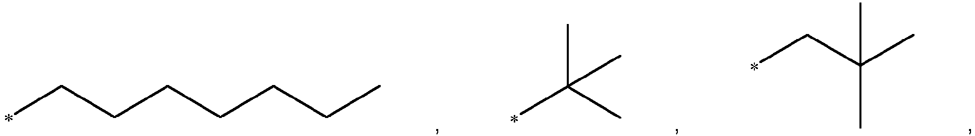 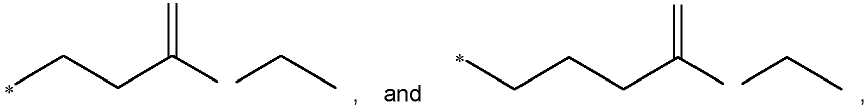 where "*" indicated a connection site of the benzotriazole compound with the R₂ except the portion of the R₂; and further preferably, the benzotriazole compound was selected from any one or more of 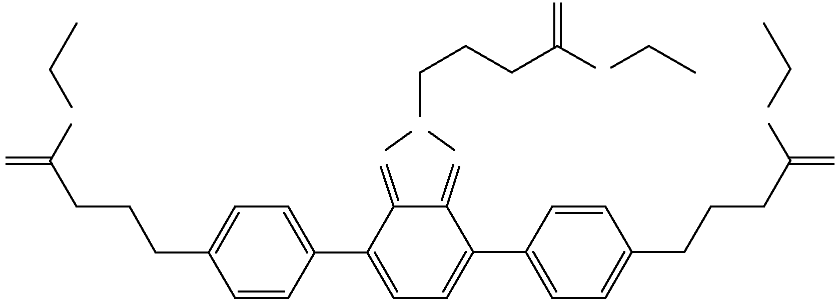 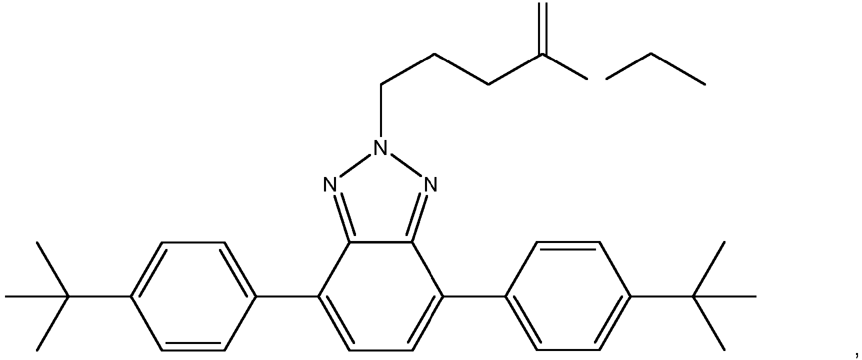 and

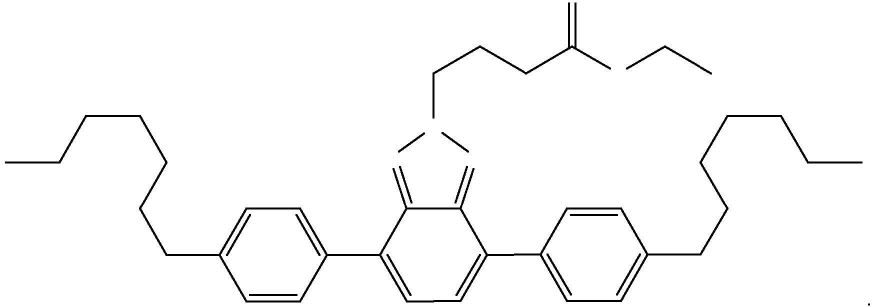

Preferably, the above R₂ and R₃ substituents were conductive to achieving their synergistic effect with R₁ to more fully protect the light-emitting core.

Preferably, the above matrix resin is selected from any one or more of EVA, PVA, PMMA, and POE, and thus better cooperate with components such as the light-conversion agent, so as to obtain the light-conversion adhesive film with excellent performance. The above matrix resin is cheap in price, facilitating reduction in cost. Definitely, other base resins may be used by those skilled in the art and are not described herein again.

In an embodiment of the present disclosure, based on a total mass of the matrix resin, light-conversion agent, and auxiliary agent being 100%, the above light-conversion adhesive film composition further included 0.01-1 % of a cross-linking agent, preferably 0.01-0.5%.

Preferably, the foregoing light-conversion agent was conductive to synergizing with the cross-linking agent, so as to improve the cross-linking effect of the cross-linking agent thereby improving the performance of the light-conversion adhesive film.

Another typical implementation of the present disclosure provided a light-conversion adhesive film. The light-conversion adhesive film was prepared by mixing and molding an adhesive film composition. The adhesive film composition was the foregoing light-conversion adhesive film composition.

In some preferred embodiments of the present disclosure, after the foregoing light-conversion adhesive film composition was well mixed, the light-conversion adhesive film was obtained through preparation using preparation processes such as melt extrusion molding at 80-120 °C. The obtained light-conversion adhesive film had excellent stability and high light-emitting efficiency, and might be effective for a long time, thereby improving the service life of a photovoltaic apparatus.

Another typical implementation of the present disclosure provided a photovoltaic module, including a light-conversion adhesive film. The light-conversion adhesive film was the above light-conversion adhesive film.

The photovoltaic module including the above light-conversion adhesive film of the present disclosure had excellent photoelectric conversion efficiency. Definitely, there might be more choices according to different requirements and application scenarios. The light-conversion adhesive film of the present disclosure was not limited to a photovoltaic apparatus, an agricultural film, architectural glass, and other fields.

The beneficial effects of the present disclosure were further described below with reference to the specific embodiments and comparative embodiments.

The benzotriazole compounds involved in Embodiments 1 to 4 below were known compounds in the related art, and their synthetic methods might be found in related preparation methods in https://doi.org/10.1016/j.tet.2014.05.016.

### Embodiment 1

A light-conversion adhesive film composition, by weight, included 98.8 parts of ethylene-vinyl acetate, 0.2 parts of a benzotriazole compound, and 1 part of polyvinyl alcohol (a molecular weight being 1000, and the mass of hydroxyl in the polyvinyl alcohol being 5% of the mass of the polyvinyl alcohol), where a structural formula of the benzotriazole compound was as follows:

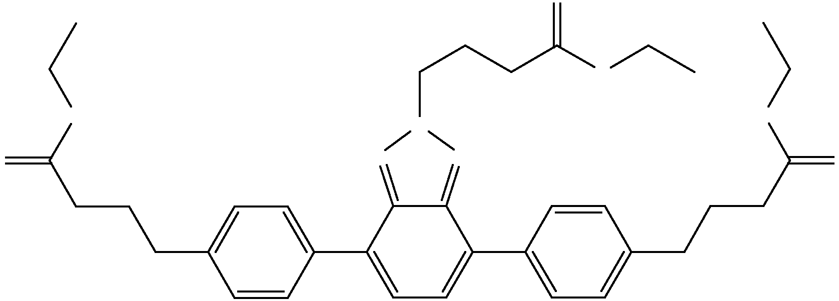

The light-conversion adhesive film composition was well mixed, and then melt extrusion and film formation were performed at 100 °C, so as to obtain a light-conversion adhesive film.

### Embodiment 2

A difference between this embodiment and Embodiment 1 lied in that, a structural formula of the benzotriazole compound was as follows:

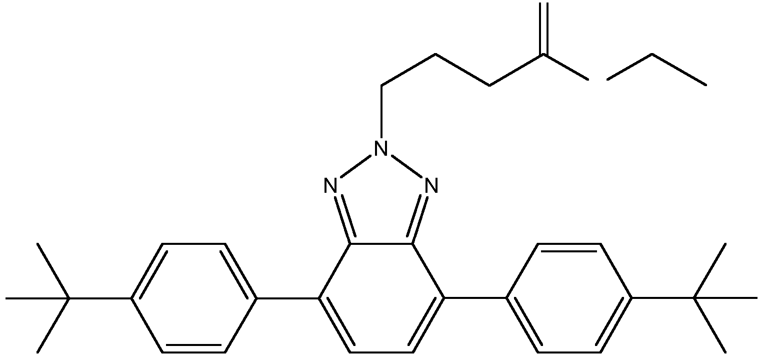

The light-conversion adhesive film was obtained finally.

### Embodiment 3

A difference between this embodiment and Embodiment 1 lied in that, a structural formula of the benzotriazole compound was as follows:

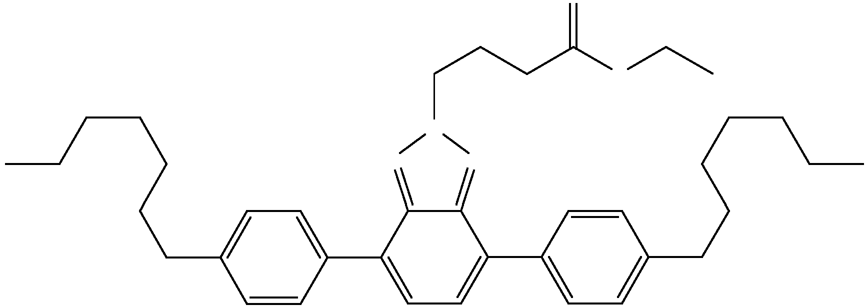

The light-conversion adhesive film was obtained finally.

### Embodiment 4

A difference between this embodiment and Embodiment 1 lied in that, a structural formula of the benzotriazole compound was as follows:

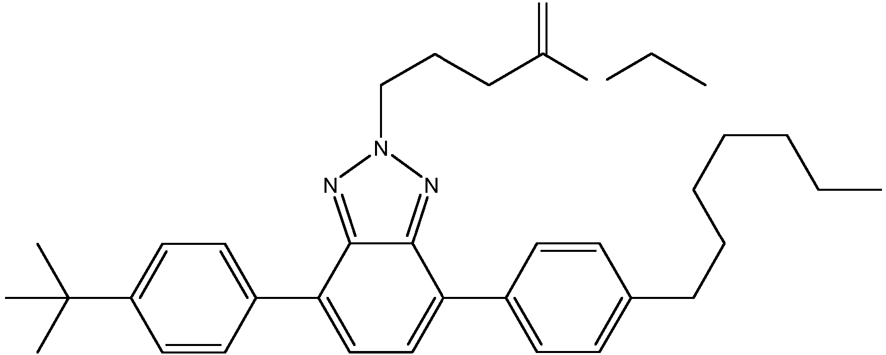

The light-conversion adhesive film was obtained finally.

### Embodiment 5

A difference between this embodiment and Embodiment 1 lied in that, by weight, the light-conversion adhesive film composition included 99.98 parts of ethylene-vinyl acetate, 0.01 parts of the benzotriazole compound, and 0.01 parts of polyvinyl alcohol (a molecular weight being 1000, and the mass of hydroxyl in a polyol compound being 5% of the mass of the polyvinyl alcohol), the light-conversion adhesive film was obtained finally.

### Embodiment 6

A difference between this embodiment and Embodiment 1 lied in that, by weight, the light-conversion adhesive film composition included 80 parts of ethylene-vinyl acetate, 10 parts of the benzotriazole compound, and 10 parts of polyvinyl alcohol (a molecular weight being 1000, and the mass of hydroxyl in a polyol compound being 5% of the mass of the polyvinyl alcohol), the light-conversion adhesive film was obtained finally.

### Embodiment 7

A difference between this embodiment and Embodiment 1 lied in that, the light-conversion adhesive film composition included, by weight, 98 of parts of the ethylene-vinyl acetate, 1 part of the benzotriazole compound, and 1 part of polyvinyl alcohol, and the light-conversion adhesive film was obtained finally.

### Embodiment 8

A difference between this embodiment and Embodiment 1 lied in that, the light-conversion adhesive film composition included, by weight, 98 of parts of the ethylene-vinyl acetate, 0.67 parts of the benzotriazole compound, and 1.33 parts of the polyvinyl alcohol, and the light-conversion adhesive film was obtained finally.

### Embodiment 9

A difference between this embodiment and Embodiment 1 lied in that, the light-conversion adhesive film composition included, by weight, 98 of parts of the ethylene-vinyl acetate, 0.039 parts of the benzotriazole compound, and 1.961 parts of the polyvinyl alcohol, and the light-conversion adhesive film was obtained finally.

### Embodiment 10

A difference between this embodiment and Embodiment 1 lied in that, the light-conversion adhesive film composition included, by weight, 98 of parts of the ethylene-vinyl acetate, 0.08 parts of the benzotriazole compound, and 1.92 parts of the polyvinyl alcohol, and the light-conversion adhesive film was obtained finally.

### Embodiment 11

A difference between this embodiment and Embodiment 1 lied in that, the mass of the hydroxyl in the polyvinyl alcohol was 0.5% of the mass of the polyvinyl alcohol, and the light-conversion adhesive film was obtained finally.

### Embodiment 12

A difference between this embodiment and Embodiment 1 lied in that, the mass of the hydroxyl in the polyvinyl alcohol was 10% of the mass of the polyvinyl alcohol, and the light-conversion adhesive film was obtained finally.

### Embodiment 13

A difference between this embodiment and Embodiment 1 lied in that, the mass of the hydroxyl in the polyvinyl alcohol was 0.1% of the mass of the polyvinyl alcohol, and the light-conversion adhesive film was obtained finally.

### Embodiment 14

A difference between this embodiment and Embodiment 1 lied in that, the mass of the hydroxyl in the polyvinyl alcohol was 20% of the mass of the polyvinyl alcohol, and the light-conversion adhesive film was obtained finally.

### Embodiment 15

A difference between this embodiment and Embodiment 1 lied in that, a polyol compound was polyethylene glycol, and the light-conversion adhesive film was obtained finally.

### Embodiment 16

A difference between this embodiment and Embodiment 1 lied in that, by weight, the light-conversion adhesive film composition included 98.5 parts of the ethylene-vinyl acetate, 1 part of the benzotriazole compound, 0.25 parts of the polyvinyl alcohol (a molecular weight being 1000, and the mass of hydroxyl in a polyol compound being 5% of the mass of the polyvinyl alcohol), 0.25 parts of polyethylene terephthalate (a molecular weight being 5000), and the light-conversion adhesive film was obtained finally.

### Embodiment 17

A difference between this embodiment and Embodiment 16 lied in that, by weight, the mass of the ethylene-vinyl acetate was unchanged, the mass ratio of the polyvinyl alcohol to the polyethylene terephthalate was 1:0.01, and the light-conversion adhesive film was obtained finally.

### Embodiment 18

A difference between this embodiment and Embodiment 16 lied in that, by weight, the mass of the ethylene-vinyl acetate was unchanged, the mass ratio of the polyvinyl alcohol to the polyethylene terephthalate was 1:0.5, and the light-conversion adhesive film was obtained finally.

### Embodiment 19

A difference between this embodiment and Embodiment 16 lied in that, by weight, the polyester compound was polyurethane, and the light-conversion adhesive film was obtained finally.

### Embodiment 20

A difference between this embodiment and Embodiment 16 lied in that, by weight, a matrix resin was ethylene-1-octene, and the light-conversion adhesive film was obtained finally.

### Embodiment 21

A difference between this embodiment and Embodiment 1 lied in that, based on a total mass of the matrix resin, light-conversion agent, and auxiliary agent being 100%, the light-conversion adhesive film composition further included 1% of a diisopropylbenzene hydroperoxide cross-linking agent, and the light-conversion adhesive film was obtained finally.

### Embodiment 22

A difference between this embodiment and Embodiment 1 lied in that, based on a total mass of the matrix resin, light-conversion agent, and auxiliary agent being 100%, the light-conversion adhesive film composition further included 0.01% of a diisopropylbenzene hydroperoxide cross-linking agent, and the light-conversion adhesive film was obtained finally.

### Embodiment 23

A difference between this embodiment and Embodiment 1 lied in that, based on a total mass of the matrix resin, light-conversion agent, and auxiliary agent being 100%, the light-conversion adhesive film composition further included 0.5% of a diisopropylbenzene hydroperoxide cross-linking agent, and the light-conversion adhesive film was obtained finally.

### Embodiment 24

A difference between this embodiment and Embodiment 21 lied in that, the cross-linking agent was a tert-butyl 2-ethylhexyl carbonate cross-linking agent, and the light-conversion adhesive film was obtained finally.

### Comparative embodiment 1

A difference between this comparative embodiment and Embodiment 1 lied in that, the R₁ was 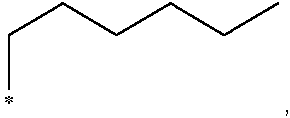 and the light-conversion adhesive film was obtained finally.

### Comparative embodiment 2

A difference between this comparative embodiment and Embodiment 1 lied in that, the R₁ was 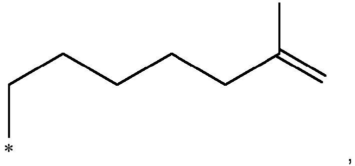 and the light-conversion adhesive film was obtained finally.

### Comparative embodiment 3

A difference between this comparative embodiment and Embodiment 1 lied in that, the R₁ was 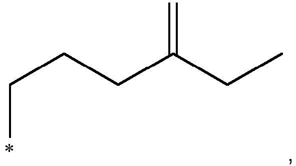 and the light-conversion adhesive film was obtained finally.

### Comparative embodiment 4

A difference between this comparative embodiment and Embodiment 19 lied in that, by weight, the light-conversion adhesive film composition included 98.5 parts of a matrix resin, 1 part of a benzotriazole compound, and 0.5 parts of polyurethane, and the light-conversion adhesive film was obtained finally.

### Comparative embodiment 5

A difference between this comparative embodiment and Embodiment 1 lied in that, by weight, the light-conversion adhesive film composition included 70 parts of a matrix resin, 15 parts of a benzotriazole compound, and 15 parts of polyvinyl alcohol (a molecular weight being 1000, and the mass of hydroxyl in a polyol compound being 5% of the mass of the polyvinyl alcohol), and the light-conversion adhesive film was obtained finally.

### Test method

Light-conversion efficiency: a Horiba spectrometer FL-3 was used, and an absolute quantum efficiency test was performed at room temperature by using an integrating sphere.

Aging test: upper and lower surfaces of the above light-conversion adhesive films obtained in Embodiments 1 to 24 and Comparative embodiments 1 to 5 are respectively stacked with a glass layer to obtain a pre-pressing assembly, and an UV300 aging test was performed in a multi-fold UV aging oven (power being 142 W, and a temperature being 70 °C).

Yellowing index: a yellowing index (ΔYI) of the pre-pressing assembly before and after the aging test was determined according to the national standard GB2409 "Test Method for Plastic Yellow Index".

Water vapor transmission rate: a test method was referred to the standard GB/T29848 "Ethylene vinyl acetate copolymer (EVA) adhesive film for photovoltaic module packaging". The above test results were listed in Table 1.

**Table 1**

| Embodiment/Comparative embodiment | Light-conversion efficiency/% | Stability (yellowing index ΔYI) | Water vapor transmission rate (g/m², 24 h) |
|---|---|---|---|
| Embodiment 1 | 88.8 | 0.52 | 22 |
| Embodiment 2 | 83.5 | 0.61 | 21 |
| Embodiment 3 | 84.1 | 0.57 | 21 |
| Embodiment 4 | 80.9 | 0.65 | 25 |
| Embodiment 5 | 75.0 | 0.46 | 20 |
| Embodiment 6 | 81.3 | 0.69 | 25 |
| Embodiment 7 | 87.4 | 0.51 | 21 |
| Embodiment 8 | 86.7 | 0.45 | 24 |
| Embodiment 9 | 88.9 | 0.47 | 25 |
| Embodiment 10 | 86.8 | 0.54 | 22 |
| Embodiment 11 | 81.6 | 0.64 | 19 |
| Embodiment 12 | 84.2 | 0.44 | 23 |
| Embodiment 13 | 78.6 | 0.67 | 19 |
| Embodiment 14 | 87.1 | 0.51 | 25 |
| Embodiment 15 | 87.7 | 0.59 | 25 |
| Embodiment 16 | 89.8 | 0.50 | 19 |
| Embodiment 17 | 88.2 | 0.49 | 18 |
| Embodiment 18 | 87.1 | 0.48 | 20 |
| Embodiment 19 | 88.1 | 0.52 | 19 |
| Embodiment 20 | 87.7 | 0.58 | 3 |
| Embodiment 21 | 85.7 | 0.41 | 16 |
| Embodiment 22 | 86.5 | 0.36 | 15 |
| Embodiment 23 | 87.4 | 0.35 | 14 |
| Embodiment 24 | 86.5 | 0.47 | 18 |
| Comparative embodiment 1 | 78.7 | 1.23 | 31 |
| Comparative embodiment 2 | 82.1 | 0.72 | 26 |
| Comparative embodiment 3 | 80.6 | 0.84 | 22 |
| Comparative embodiment 4 | 80.2 | 0.79 | 21 |
| Comparative embodiment 5 | 81.1 | 1.74 | 38 |

It was to be noted that, the problems in Comparative embodiment 1 and Comparative embodiment 5 were that the light-conversion adhesive film was poor in stability and too high in water vapor transmission rate, thus greatly reducing the service life of the light-conversion adhesive film and a corresponding photovoltaic module thereof.

The problem with R₁ being carboxyl in Comparative embodiment 2 was that the carboxyl reacted with the sodium silicate in the adjacent glass layer of the light-conversion adhesive film to generate sodium carboxylate, thus affecting film formation, and at the same time the carboxyl, when used in a light-conversion adhesive film system, caused the light-conversion adhesive film to corrode a ribbon, a bus bar, and the like of the photovoltaic module, and was poor in stability.

The problem with R₁ being carbonyl in Comparative embodiment 3 was that the light-conversion adhesive film was poor in stability and too high in water vapor transmission rate, thus greatly reducing the service life of the light-conversion adhesive film and a corresponding photovoltaic module thereof.

In Comparative embodiment 4, the absence of the polyol compound led to a decrease in solubility and a deterioration in transmittance of the light-conversion adhesive film.

It might be seen from the above description that, in the above embodiments of the present disclosure, the following technical effects were realized.

The ester group contained in the R₁ at the No. 2 N position of benzotriazole provided a first protective layer for the benzotriazole light-emitting core. Moreover, the ester group having an oxygen atom might also form an interaction such as a hydrogen bond with the matrix resin to improve the compatibility of the light-conversion agent and the matrix resin, thereby providing a second protective layer to the light-emitting core structure. The benzotriazole compound was not very compatible with the matrix resin due to its high rigidity. An alkyl main chain of the polyol compound auxiliary agent had a component similar to the matrix resin, and a hydrogen bond was formed by a hydroxyl functional group contained in a side chain of the polyol compound auxiliary agent and an ester functional group of the light-conversion agent, such that the compatibility of the light-conversion agent and the matrix resin was improved under the dual action of similar compatibility and hydrogen bonding, and the protection effect of the matrix resin to the light-conversion agent was achieved at the same time, so as to provide a third protective layer for the light-emitting core structure, thereby improving the stability of the light-conversion agent under the above multiple protective effects, and optimizing a film formation effect. Furthermore, the motion of the light-conversion agent inside the matrix resin was further limited due to the effect of the hydrogen bond, an energy loss during molecular luminescence was reduced, the rigidity of molecules in the light-conversion agent was improved, and the purpose of light-conversion efficiency was improved finally. Therefore, the light-conversion adhesive film obtained by using the light-conversion adhesive film composition of the present disclosure had excellent light stability and high light-emitting efficiency, and might be effective for a long time, thereby improving the service life of a photovoltaic apparatus.

The above are only the preferred embodiments of the present disclosure and are not intended to limit the present disclosure. For those skilled in the art, the present disclosure may have various modifications and variations. Any modifications, equivalent replacements, improvements and the like made within the spirit and principle of the present disclosure all fall within the scope of protection of the present disclosure.

## Claims

1. A light-conversion adhesive film composition, by weight percentage, comprising: 80-99.98% of a matrix resin;
0.01-10% of a light-conversion agent; and
0.01-10% of an auxiliary agent, wherein
the light-conversion agent is a benzotriazole derivative, and a structural general formula of the benzotriazole derivative is shown in Formula I, Formula II, or Formula III: 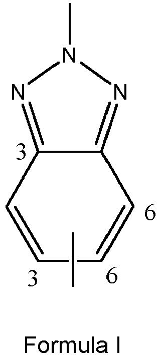 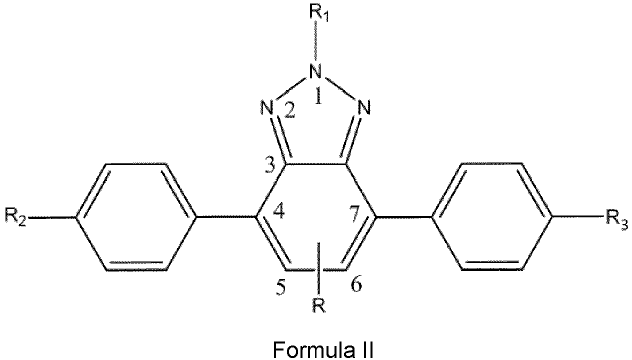 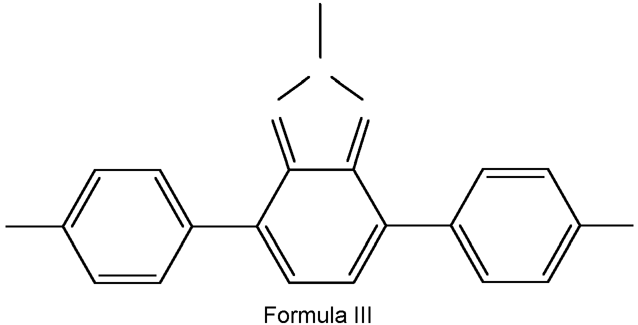
wherein
in Formula I, an R substituent is 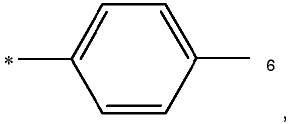 there is at least one R substituent in Sites 4 and 7 of the benzotriazole derivative, and there is at least one R substituent in Sites 5 and 6 of the benzotriazole derivative;
R₁ and R₂ are each independently selected from any one of H, substituted or unsubstituted C₁-C₂₀ alkyl, C₃-C₂₀ alkyl with at least one methylene substituted by -COO- or -O-, and substituted or unsubstituted C₂-C₂₀ alkenyl, wherein substituents in the R₁ and R₂ are each independently selected from any one or more of methyl, ethyl, propyl, butyl, trifluoromethyl, and nitro;
in Formula II, R₁ and R are each independently selected from any one of substituted or unsubstituted CH₂=HC-R'-*, substituted or unsubstituted C₁-C₂₀ alkyl, substituted or unsubstituted C₁-C₂₀ alkoxy, substituted or unsubstituted C₁-C₂₀ easter group, and substituted or unsubstituted C₁-C₂₀ amino, and R' is a straight bond or C₁-C₂₀ alkylene;
R₂ and R₃ are each independently selected from any one of H, C₁-C₂₀ hydrocarbyl, and C₃-C₂₀ hydrocarbyl with at least one methylene substituted by -COO-;
a maximum absorption wavelength of the light-conversion agent is located between 300 and 400 nm, and a maximum emission wavelength is greater than 400 nm;
in Formula III, R₁ is C₃-C₂₀ alkyl with at least one methylene substituted by -COO-, and R₂ and R₃ are each independently selected from any one or more of H, C₁-C₂₀ alkyl, and C₃-C₂₀ alkyl with at least one methylene substituted by -COO-;
when the structural general formula of the benzotriazole compound is the structure shown in Formula III, the auxiliary agent comprises a polyol compound.

2. The light-conversion adhesive film composition according to claim 1, wherein when the structural general formula of the benzotriazole compound is the structure shown in Formula I, the R₁ and the R₂ are each independently selected from any one of substituted or unsubstituted C₅-C₁₀ alkyl, C₅-C₁₀ alkyl with at least one methylene substituted by -COO- or -O-, and C₅-C₁₀ alkenyl; and preferably, the R₁ and the R₂ are each independently selected from any one of any one of groups of pentyl, hexyl, heptyl, octyl, nonyl, and decyl each independently with at least one methylene substituted by -COO- or -O-, and from any one of pentyl, hexyl, heptyl, octyl, nonyl, decyl, pentenyl, hexenyl, heptenyl, octenyl, nonenyl, and decenoyl.

3. The light-conversion adhesive film composition according to claim 1 or 2, wherein when the structural general formula of the benzotriazole compound is the structure shown in Formula I, the benzotriazole derivative is selected from any one or more of 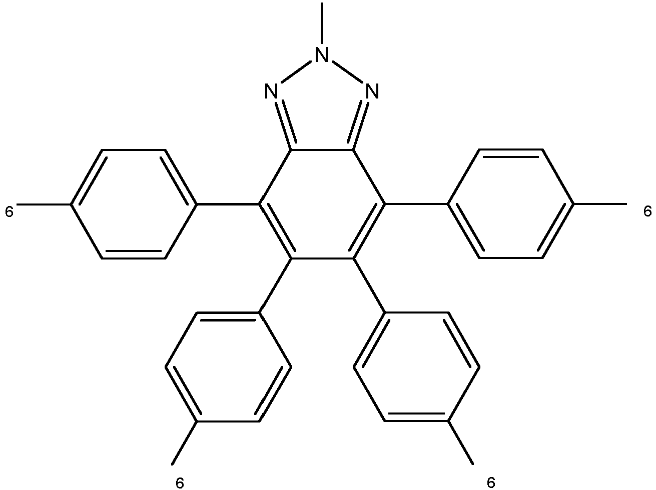 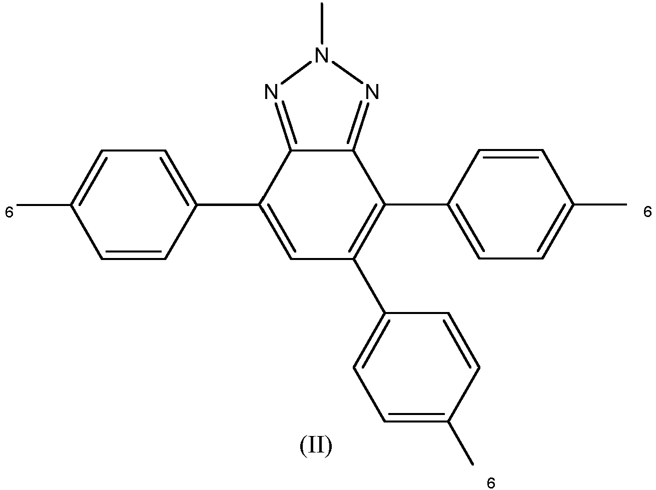 and 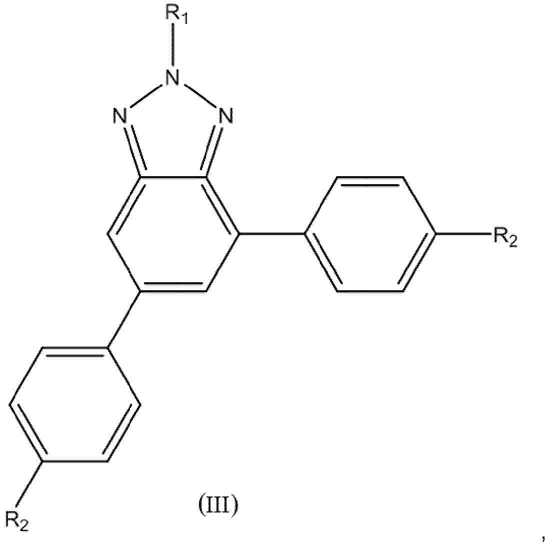 R₁, R₃, R₄, R₅, and R₆ are each independently selected from any one of any one of groups of pentyl, hexyl, heptyl, octyl, nonyl, and decyl each independently with at least one methylene substituted by -COO- or -O-, and from any one of pentyl, hexyl, heptyl, octyl, nonyl, decyl, pentenyl, hexenyl, heptenyl, octenyl, nonenyl, and decenoyl.

4. The light-conversion adhesive film composition according to any one of claims 1 to 3, wherein when the structural general formula of the benzotriazole compound is the structure shown in Formula I, the R₁, R₃, R₄, R₅, and R₆ are each independently selected from any one or more of tert-butyl, octyl, nonyl, hexenyl, heptenyl, octenyl, a butyric acid ethyl ester group, a butyric acid propyl ester group, a butyric acid butyl ester group, dipropyl ether, dibutyl ether, and butyl pentyl ether.

5. The light-conversion adhesive film composition according to claim 3, wherein when the structural general formula of the benzotriazole compound is the structure shown in Formula I, the benzotriazole derivative comprises benzotriazole derivatives with structures shown in Formula (I) and (II), preferably, a molar ratio of the benzotriazole derivatives with structures shown in Formula (I) and (II) is 1:0.01-0.5.

6. The light-conversion adhesive film composition according to any one of claims 1 to 5, wherein when the structural general formula of the benzotriazole compound is the structure shown in Formula I, the auxiliary agent comprises a cross-linking agent and/or an auxiliary cross-linking agent; and preferably, a weight percentage of the cross-linking agent is 0.005-5%, and/or a weight percentage of the auxiliary cross-linking agent is 0.005-5%.

7. The light-conversion adhesive film composition according to any one of claims 1 to 6, wherein when the structural general formula of the benzotriazole compound is the structure shown in Formula I, the auxiliary agent further comprises a polyol compound; preferably, the mass of hydroxyl in the polyol compound is 0.1-20% of the mass of the polyol compound, preferably 0.5-10%; preferably, a molecular weight of the polyol compound is 500-80000; and preferably, the polyol compound is selected from any one or more of a polyvinyl alcohol compound, polyethylene glycol, and polypropylene glycol.

8. The light-conversion adhesive film composition according to claim 1, wherein when the structural general formula of the benzotriazole compound is the structure shown in Formula II, any methylene in the R₁ and R is substituted by any one of 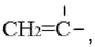 , -COO-, and -O-; preferably, R' is a straight bond or C₁-C₈ alkylene, and the R₁ and R are each independently selected from substituted or unsubstituted C₁-C₈ alkyl, substituted or unsubstituted C₁-C₈ alkoxy, substituted or unsubstituted C₁-C₈ ester group, and substituted or unsubstituted C₁-C₈ amino; preferably, the R₁ and R are each independently selected from any one of C₁-C₈ straight chain alkyl, C₃-C₈ branched alkyl, and C₁-C₈ alkoxy; preferably, the R₁ and R are each independently selected from any one of methyl, methoxy, ethyl, ethoxy, propyl, propoxy, butyl, butoxyl, pentyl, pentyloxy, hexyl, hexyloxy, heptyl, heptyloxy, octyl, octyloxy, vinyl, allyl, alkenylbutyl, alkenylpentyl, alkenylhexyl, alkenylheptyl, alkenyloctyl, 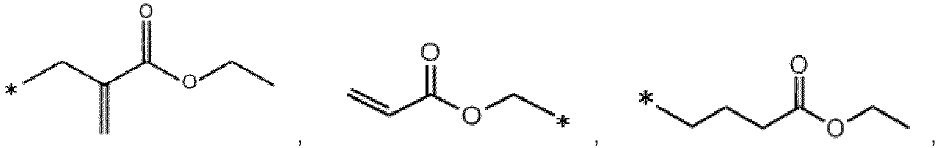 and 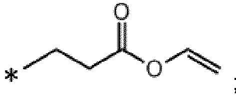 and further preferably, the R₁ and R are each independently selected from any one of alkenyloctyl, heptyl,

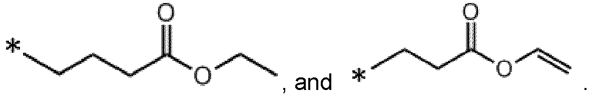

9. The light-conversion adhesive film composition according to claim 1 or 8, wherein when the structural general formula of the benzotriazole compound is the structure shown in Formula II, the R1 and R respectively are substituents capped with unsaturated substituted functional groups, preferably, the unsaturated substituted functional group is selected from any one of alkenyl hydrocarbyl, an acrylic group, and an acrylate group; preferably, the unsaturated substituted functional group is vinyl; and/or
when the R₁ and R have substituents, the substituent is selected from any one or more of methyl, ethyl, propyl, butyl, trifluoromethyl, and nitro.

10. The light-conversion adhesive film composition according to any one of claims 1, 8, or 9, wherein when the structural general formula of the benzotriazole compound is the structure shown in Formula II, the R₂ and the R₃ are each independently selected from any one or more of H, C₁-C₁₀ hydrocarbyl, and C₃-C₁₀ hydrocarbyl with at least one methylene substituted by -COO-, and preferably, the R₂ and the R₃ are each independently selected from any one or more of 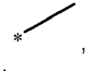 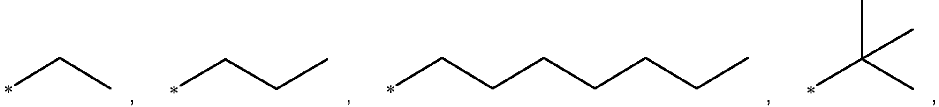 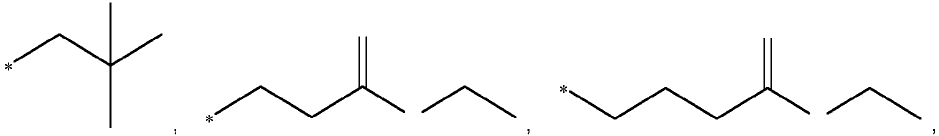 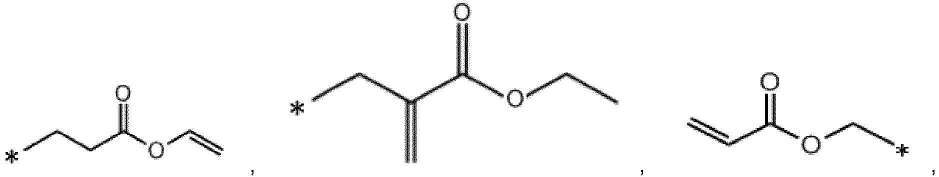 and 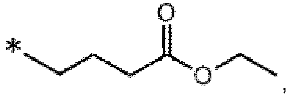 wherein "*" indicates connection sites of the R₂ and the R₃ on benzene rings on which they are located.

11. The light-conversion adhesive film composition according to any one of claims 1, 8 to 10, wherein when the structural general formula of the benzotriazole compound is the structure shown in Formula II, the benzotriazole derivative is selected from any one or more of

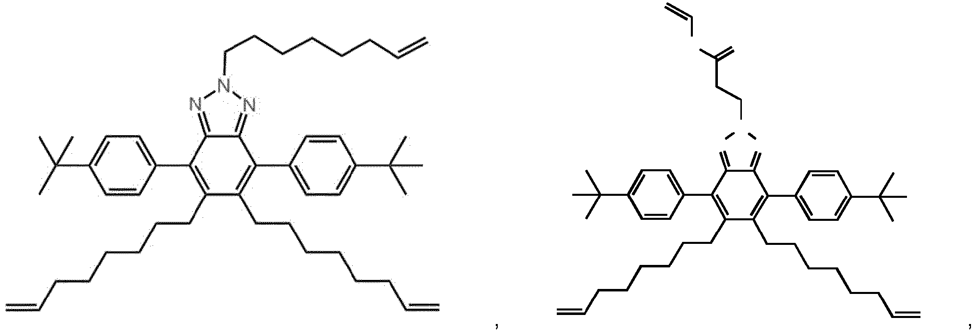

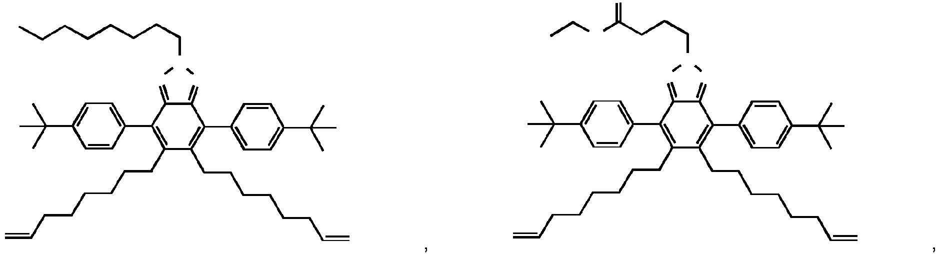

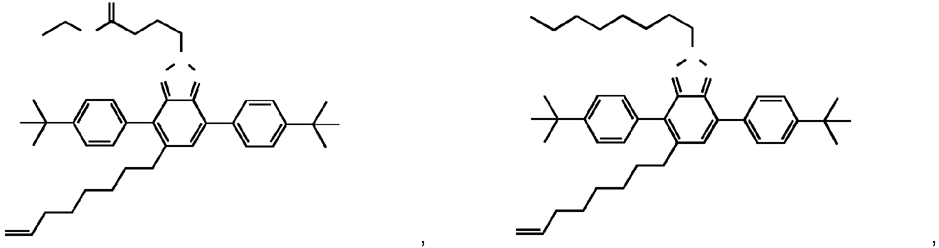

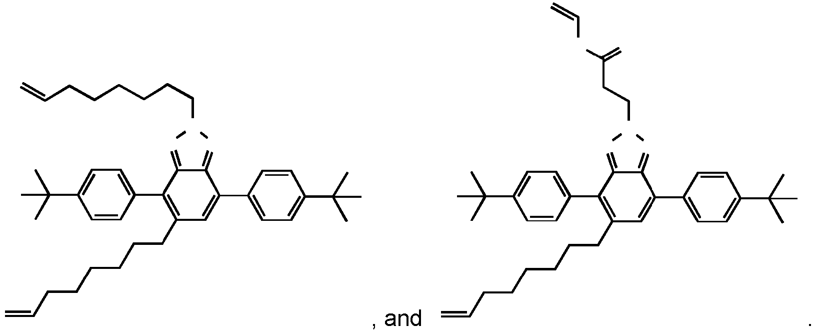

12. The light-conversion adhesive film composition according to any one of claims 1, 8 to 11, wherein when the structural general formula of the benzotriazole compound is the structure shown in Formula II, the auxiliary agent comprises a cross-linking agent and/or an auxiliary cross-linking agent; and preferably, a weight percentage of the cross-linking agent is 0.005-5%, and/or a weight percentage of the auxiliary cross-linking agent is 0.005-5%.

13. The light-conversion adhesive film composition according to any one of claims 1, 8 to 12, wherein when the structural general formula of the benzotriazole compound is the structure shown in Formula II, the auxiliary agent further comprises a polyol compound; preferably, the mass of hydroxyl in the polyol compound is 0.1-20% of the mass of the polyol compound, preferably 0.5-10%; preferably, a molecular weight of the polyol compound is 500-80000; and preferably, the polyol compound is selected from any one or more of a polyvinyl alcohol compound, polyethylene glycol, and polypropylene glycol.

14. The light-conversion adhesive film composition according to claim 1, wherein when the structural general formula of the benzotriazole compound is the structure shown in Formula III, the light-conversion adhesive film composition comprises, by weight percentage:
98%-99.98% of the matrix resin;
0.01%-1% of the light-conversion agent; and
0.01%-1% of the auxiliary agent, wherein
further preferably, a mass ratio of the light-conversion agent to the auxiliary agent is 1:2-500, preferably 1:2-50.

15. The light-conversion adhesive film composition according to claim 1 or 14, wherein when the structural general formula of the benzotriazole compound is the structure shown in Formula III, the mass of hydroxyl in a polyol compound is 0.1-20% of the mass of the polyol compound, preferably 0.5-10%; preferably, a molecular weight of the polyol compound is 500-80000; and preferably, the polyol compound is selected from any one or more of a polyvinyl alcohol compound, polyethylene glycol, and polypropylene glycol.

16. The light-conversion adhesive film composition according to any one of claims 1, 14 or 15, wherein when the structural general formula of the benzotriazole compound is the structure shown in Formula III, the auxiliary agent further comprises a polyester compound; preferably, a molecular weight of the polyester compound is 500-80000; preferably, a mass ratio of the polyol compound to the polyester compound is 1:0.01-1; preferably, the mass ratio of the polyol compound to the polyester compound is 1:0.1-0.5; preferably, the polyester compound is aliphatic polyester and/or aromatic polyester; preferably, the aromatic polyester is polyethylene terephthalate; preferably, the aliphatic polyester is selected from any one or more of a polyester compound obtained through polymerization of C₂-C₁₂ aliphatic diprotic acid and C₂-C₁₂ alkyl dihydric alcohol, and polyurethane; and preferably, the aliphatic polyester is selected from any one or more of polyurethane, poly butylenes succinate, poly(methyl methacrylate), polyethylene glycol ester, and polyhydroxybutyrate.

17. The light-conversion adhesive film composition according to any one of claims 1, 14 to 16, wherein when the structural general formula of the benzotriazole compound is the structure shown in Formula III, the R₁ is C₃-C₁₀ alkyl with at least one methylene substituted by -COO-, and preferably, the R₁ is selected from any one or more of 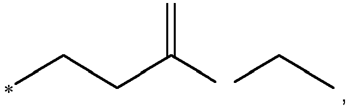 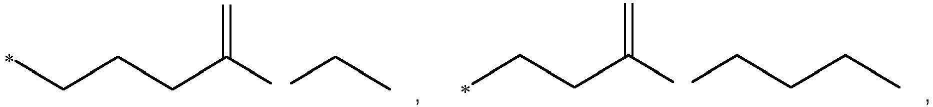 and 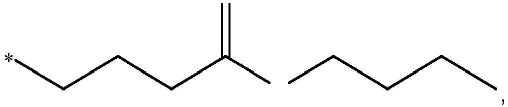 wherein "*" indicates a connection site of the benzotriazole compound with the R₁ except the portion of the R₁.

18. The light-conversion adhesive film composition according to any one of claims 1, 14 to 17, wherein when the structural general formula of the benzotriazole compound is the structure shown in Formula III, the R₂ and the R₃ are each independently selected from any one or more of H, C₁-C₁₀ alkyl, and C₃-C₁₀ alkyl with at least one methylene substituted by -COO-, and preferably, the R₂ and the R₃ are each independently selected from any one or more of 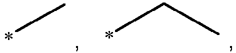 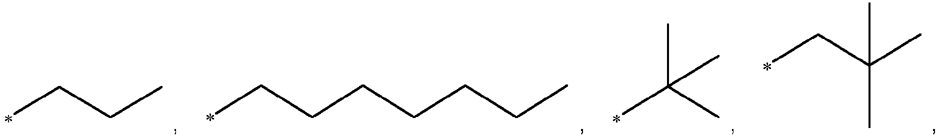 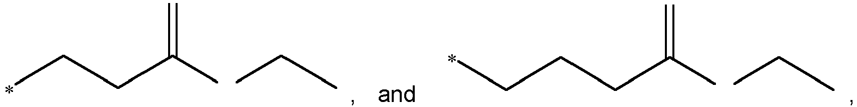 wherein "*" indicates a connection site of the benzotriazole compound with the R₂ except the portion of the R₂; and
further preferably, the R₂ is the same as the R₃, and preferably, the benzotriazole compound is selected from any one or more of 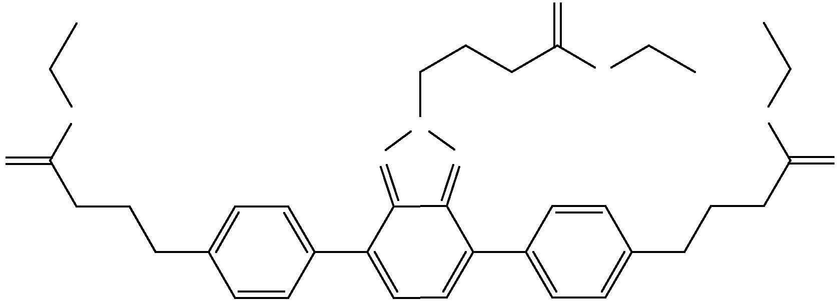 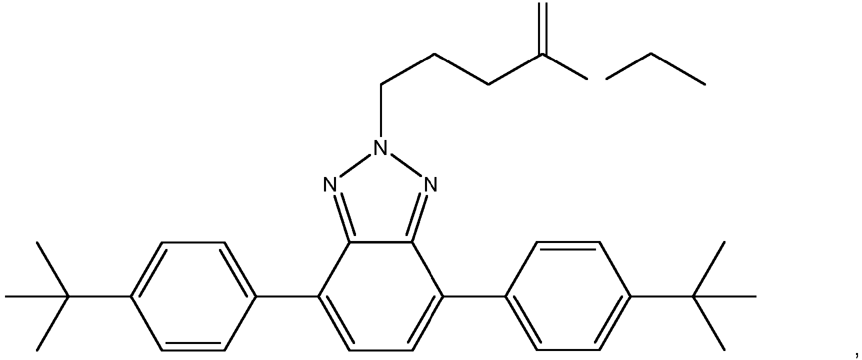 and

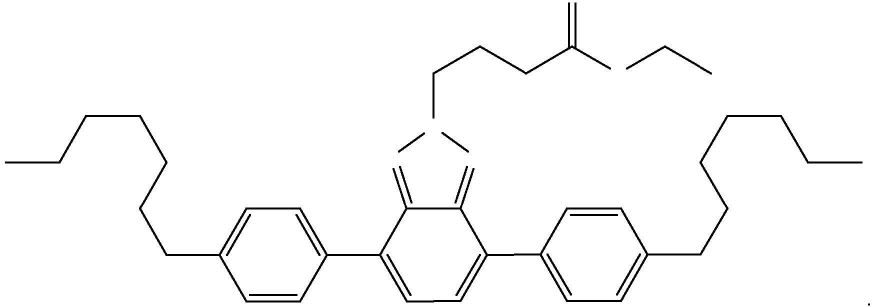

19. The light-conversion adhesive film composition according to any one of claims 1, 14 to 18, wherein when the structural general formula of the benzotriazole compound is the structure shown in Formula III, based on a total mass of the matrix resin, the light-conversion agent, and the auxiliary agent being 100%, the light-conversion adhesive film composition further comprises 0.01-1% of a cross-linking agent, preferably 0.01-0.5%.

20. The light-conversion adhesive film composition according to any one of claims 1 to 19, wherein the matrix resin is selected from any one or more of EVA, PVA, PMMA, POE, and organosilicon.

21. A light-conversion adhesive film, prepared by mixing and molding an adhesive film composition, wherein the adhesive film composition is the light-conversion adhesive film composition according to any one of claims 1 to 20.

22. A photovoltaic module, comprising a light-conversion adhesive film, wherein the light-conversion adhesive film is the light-conversion adhesive film according to claim 21.
